# EUROPEAN PATENT APPLICATION

(11) **EP 4 407 692 A1**
(43) Date of publication of application: **31.07.2024**
(21) Application number: 22959264.7
(22) Date of filing: 23.09.2022
(51) Int. Cl.: H01L 29/78, H01L 29/423, H01L 29/06, H01L 21/336, H01L 29/16

(54) **SEMICONDUCTOR DEVICE, MANUFACTURING METHOD, POWER CONVERSION CIRCUIT, AND VEHICLE**

(71) Applicant: Huawei Digital Power Technologies Co., Ltd., Shenzhen, Guangdong 518043 (CN)
(72) Inventor: HAMADA, Kimimori, Shenzhen, Guangdong 518043 (CN); HU, Fei, Shenzhen, Guangdong 518043 (CN)
(74) Representative: Maiwald GmbH
(86) International application number: PCT/CN2022/121116
(87) International publication number: WO 2024/060262

(57) **Abstract**

This application discloses a semiconductor device, a manufacturing method, a power conversion circuit, and a vehicle. The semiconductor device includes an N-type semiconductor substrate, a first epitaxial layer, a plurality of gate trenches disposed at intervals, a gate, an interlayer dielectric layer, a source, and a drain. The plurality of gate trenches are disposed at the first epitaxial layer. The plurality of gate trenches extend in a first direction. The gate includes a first gate and a second gate that are in contact with each other. The first gate is filled in the gate trench, and is spaced apart by a gate dielectric layer. The second gate is disposed on top of the first epitaxial layer and is spaced apart by the gate dielectric layer. The interlayer dielectric layer covers a side that is of the gate and that is away from the semiconductor substrate, and has contact holes that extend in a second direction. The source is disposed on a side that is of the interlayer dielectric layer and that is away from the semiconductor substrate, and is in contact with the first epitaxial layer through the contact hole. The drain is disposed on a side that is of the semiconductor substrate and that is away from the first epitaxial layer. In this way, total on-resistance of the device is reduced.

## Description

### TECHNICAL FIELD

This application relates to the field of semiconductor technologies, and in particular, to a semiconductor device, a manufacturing method, a power conversion circuit, and a vehicle.

### BACKGROUND

Compared with a silicon (Si) material, a silicon carbide (SiC) material has advantages such as a wide band gap, a high critical breakdown electric field, high thermal conductivity, and a high electron saturation drift velocity. Compared with an insulated gate bipolar transistor (insulated gate bipolar transistor, IGBT) made of the Si material, a metal-oxide-semiconductor field-effect transistor (metal-oxide-semiconductor field-effect transistor, MOSFET) made of the SiC material has properties such as a high breakdown voltage and a low conduction voltage drop. In addition, a monopole conductive property enables the SiC MOSFET to have a faster switching speed, a lower conduction loss, and a lower switching loss than the Si IGBT. Therefore, the SiC MOSFET has replaced the Si IGBT in some application scenarios such as fields of an on-board micro controller unit (micro controller unit, MCU) and an on-board battery charger (on-board battery charger, OBC).

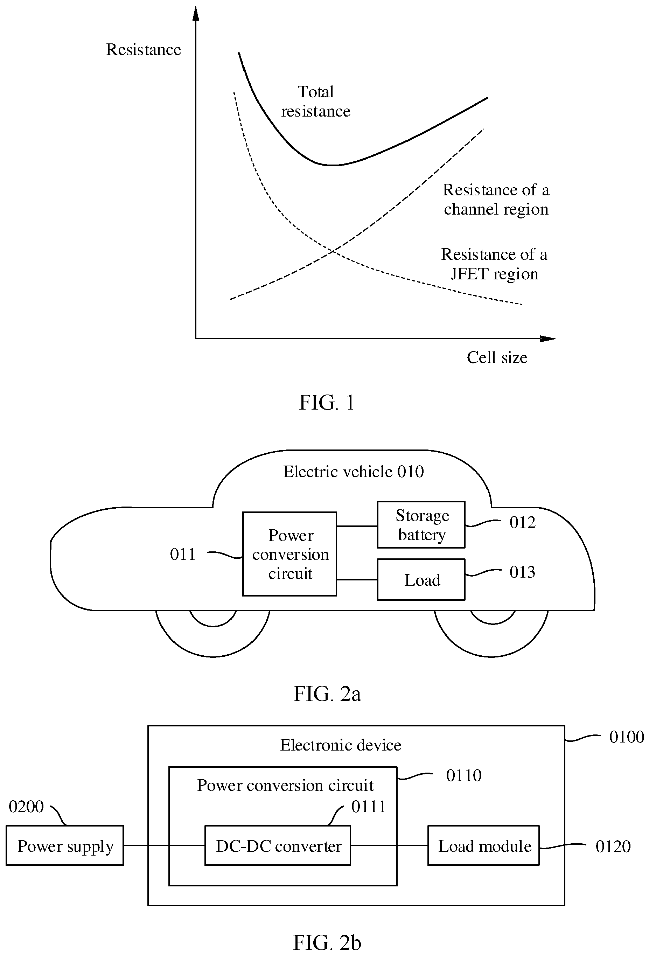

Compared with a device of a common planar gate structure, in a SiC MOSFET device of a trench gate structure, a gate is built into a SiC body, so that a conductive channel of the device is changed from a planar direction to a vertical direction. Therefore, a cell size of the device is clearly reduced, and density of the conductive channel of the device is greatly improved, so that on-resistance of a chip can be significantly reduced, and a through-current capability can be improved. The trench gate structure has become a mainstream technical direction of future devices. However, in the SiC MOSFET device of the trench gate structure, there is an obvious contradiction relationship between resistance of a channel region and resistance of a junction field effect transistor (junction field effect transistor, JFET) region. Refer to FIG. 1. A horizontal coordinate represents a cell size, and a vertical coordinate represents resistance. It may be learned from FIG. 1 that a spacing between trench gate structures in a SiC MOSFET device is reduced, so that the cell size of the SiC MOSFET device can be reduced, density of a conductive channel can be increased, and resistance of a channel region can be reduced. However, a through-current width of the JFET region is also reduced accordingly, leading to an increase in the resistance of the JFET region. Consequently, total on-resistance of the entire SiC MOSFET device is increased instead, device performance is reduced, and a chip loss is increased.

### SUMMARY

This application provides a semiconductor device, a manufacturing method, a power conversion circuit, and a vehicle, to reduce total on-resistance of the device, improve device performance, and reduce a device loss.

According to a first aspect, an embodiment of this application provides a semiconductor device, and the semiconductor device includes an N-type semiconductor substrate, a first epitaxial layer, a plurality of gate trenches disposed at intervals, a gate, an interlayer dielectric layer, a source, and a drain. The first epitaxial layer is disposed on the semiconductor substrate. The plurality of gate trenches disposed at intervals are disposed at the first epitaxial layer, and the plurality of gate trenches extend to the first epitaxial layer in a third direction perpendicular to a plane on which the semiconductor substrate is located (for example, the first epitaxial layer includes a first N-type semiconductor region, a second N-type semiconductor region, a first P-type semiconductor region, and source regions, where the first N-type semiconductor region is disposed between the second N-type semiconductor region and the semiconductor substrate, the first P-type semiconductor region is disposed on a side that is of the first N-type semiconductor region and that is away from the semiconductor substrate, the source region is disposed on a side that is of the first P-type semiconductor region and that is away from the semiconductor substrate, and in the third direction perpendicular to the plane on which the semiconductor substrate is located, the gate trench extends to the first N-type semiconductor region.) The plurality of gate trenches extend in a first direction parallel to the plane on which the semiconductor substrate is located. The plurality of gate trenches are arranged in a second direction parallel to the plane on which the semiconductor substrate is located. A tightly arranged array of the gate trenches is manufactured at the first epitaxial layer. The gate includes a first gate and a second gate that are in contact with each other. The first gate is filled and disposed in the gate trench, and is spaced apart by a gate dielectric layer, so that the first gate is built at the first epitaxial layer made of a SiC material. The second gate is disposed on top of the first epitaxial layer made of the SiC material and is spaced apart by the gate dielectric layer. The first gate and the first P-type semiconductor region form a trench gate structure of a SiC MOSFET device by using the gate dielectric layer. In other words, the semiconductor device provided in this embodiment of this application is a SiC MOSFET of the trench gate structure. The interlayer dielectric layer covers a side that is of the gate and that is away from the semiconductor substrate. In other words, the interlayer dielectric layer covers a side that is of the entire semiconductor substrate and that has the gate. The source is disposed on a side that is of the interlayer dielectric layer and that is away from the semiconductor substrate. In other words, the source covers the entire interlayer dielectric layer. The drain is disposed on a side that is of the semiconductor substrate and that is away from the first epitaxial layer. In other words, the drain covers a side that is of the semiconductor substrate and on which the first epitaxial layer is not disposed. In actual application, if a signal needs to be transmitted between the source and the drain, contact holes extending in the second direction may be disposed at the interlayer dielectric layer. To avoid contact between the source and the gate, an orthographic projection of the contact hole on the semiconductor substrate does not overlap an orthographic projection of the gate on the semiconductor substrate. In other words, in the third direction, the contact hole is disposed without overlapping the gate. In addition, the contact hole exposes a partial region of the first epitaxial layer (for example, the contact hole exposes a partial region of the source region), so that the source is in contact with the first epitaxial layer (for example, the source region) through the contact hole. When the gate controls a channel to be conducted, a signal may be transmitted between the source and the drain.

According to the semiconductor device provided in this embodiment of this application, the tightly arranged array of the gate trenches is manufactured at the first epitaxial layer, and the first gate is disposed in the gate trench. In the second direction, parts of two side walls of the gate trench that corresponds to the first gate are channels. In addition, an extension direction of the contact hole disposed at the interlayer dielectric layer is the second direction, and an extension direction of the gate trench (or the first gate) is the first direction. In this case, the extension direction of the contact hole is perpendicular to the extension direction of the gate trench (or the first gate). In other words, the contact hole is disposed in a direction perpendicular to the gate trench (or the first gate). Therefore, in comparison with a manner, in a conventional technology, in which the gate trench is disposed in parallel to the contact hole, according to the semiconductor device provided in this embodiment of this application, a limitation imposed by the contact hole on a trench spacing between adjacent gate trenches in the second direction is reduced, so that the gate trench can be manufactured more tightly. In other words, the first gate is also tighter. Therefore, an array density of the gate trench of the semiconductor device provided in this embodiment of this application may be far higher than an array density of a gate trench of a device structure in a conventional technology. Therefore, a channel density of the SiC MOSFET is increased, total on-resistance of the device is clearly reduced, device performance is improved, and a device loss is reduced.

In this application, the semiconductor substrate may be a silicon carbide single crystal substrate doped with a pentavalent element. A SiC material that is generated through epitaxial growth and that is doped with a corresponding impurity may be used for the first epitaxial layer. For example, the first N-type semiconductor region is a partial region of the first epitaxial layer formed through epitaxial growth, and the second N-type semiconductor region and the source region may be formed by doping the first epitaxial layer by using an ion implantation process. In addition, the N-type semiconductor region is mainly doped with an N-type impurity, for example, nitrogen (N), phosphorus (P), or arsenic (As). For example, a doping concentration of the semiconductor substrate is greater than a doping concentration of the second N-type semiconductor region. The doping concentration of the second N-type semiconductor region is greater than a doping concentration of the first N-type semiconductor region. A doping concentration of the source region is greater than the doping concentration of the second N-type semiconductor region.

In this application, the first P-type semiconductor region may be formed by doping the first epitaxial layer by using the ion implantation process. In addition, the P-type semiconductor region is mainly doped with a P-type impurity, for example, boron (B), aluminum (Al), or gallium (Ga).

For example, the first gate is disposed in the gate trench, which means that the first gate extends in the first direction. The second gate may be disposed to extend in the second direction, so that a part of the second gate is disposed at the first epitaxial layer and is spaced apart by the gate dielectric layer, and the other part is disposed on the first gate and is in direct contact with the first gate.

A material of the gate is not limited in this application. For example, the material of the gate may be a polycrystalline silicon material, or may be another material having a good conductive property, for example, metal (for example, W, Al, Ti, Cu, Mo, or Pt).

A material for forming the interlayer dielectric layer is not limited in this application. For example, the material for forming the interlayer dielectric layer may be a dielectric material. The dielectric material includes but is not limited to silicon dioxide (SiO₂), silicon nitride (SiNO), silicon carbon oxide (SiCO), silicon nitride (SiNx), and the like.

A material for forming the source and the drain is not limited in this application. For example, the material for forming the source and the drain may be a metal material. For example, the metal material may include W, Al, Ti, Cu, Mo, or Pt.

In this application, the first direction, the second direction, and the third direction are set in a cross manner. For example, the first direction, the second direction, and the third direction are set to be perpendicular to each other.

According to the semiconductor device provided in this embodiment of this application, a first side wall and a second side wall of the gate trench each are disposed with a third P-type semiconductor region, so that the first P-type semiconductor region (that is, the first P-type semiconductor region below the fourth P-type semiconductor region) disposed on the first side wall and the second side wall of the gate trench is not controlled by the first gate and does not have performance of a channel. Therefore, in the second direction, a part of a side wall of the gate trench that corresponds to the first gate is a channel.

In some possible implementations of this application, the plurality of gate trenches in the semiconductor device may be divided into one or more trench groups, and two or more contact holes are disposed. In addition, one trench group is disposed between two adjacent contact holes, and the contact hole spans across the trench group in the second direction, so that signals evenly flow.

In some possible implementations of this application, quantities of gate trenches in different trench groups may be the same. In this way, the gate trenches can be evenly distributed. For example, different trench groups each are disposed with five gate trenches. It should be noted that, in actual application, a quantity of gate trenches in the trench group may be determined based on an actual application requirement. This is not limited in this application.

In some possible implementations of this application, alternatively, quantities of gate trenches in some trench groups may be the same, and quantities of gate trenches in the other trench groups may be different. Alternatively, quantities of gate trenches in different trench groups may be different. In actual application, the quantity of gate trenches in the trench group may be determined based on an actual application requirement. This is not limited in this application.

In some possible implementations of this application, in the second direction, two gate trenches that are located at edges of the trench group are respectively defined as a first edge trench and a second edge trench, and the contact hole extends, in the second direction, from a side that is of the first edge trench and that is away from the second edge trench to a side that is of the second edge trench and that is away from the first edge trench. In other words, the contact hole is a continuous opening, and gate trenches in different trench groups do not communicate with each other.

The semiconductor device provided in this embodiment of this application is a SiC MOSFET device of the trench gate structure. In the SiC MOSFET device of the trench gate structure, the gate dielectric layer at a bottom and a corner of a trench gate structure of the SiC MOSFET device bears extremely high electric field strength when the device works, is a weak point for electric field breakdown, and easily causes a reliability failure when the device works for a long period. Therefore, how to effectively shield the gate dielectric layer from a high electric field stress becomes a key to a high robustness/reliability design of the device. In some possible implementations of this application, a second P-type semiconductor region is further disposed at the first epitaxial layer. The second P-type semiconductor region is disposed below the gate trench, and the second P-type semiconductor region is disposed in direct contact with a bottom of the gate trench. In addition, in this application, the second P-type semiconductor region may be connected to the source. When the SiC MOSFET device works, a voltage is loaded on the source. Because the second P-type semiconductor region is connected to the source, the voltage loaded on the source is input to the second P-type semiconductor region, so that the second P-type semiconductor region also has a corresponding voltage, an electric field of the gate dielectric layer at the bottom of the gate trench can be effectively shielded, and working robustness of the device is improved.

A thickness of the second P-type semiconductor region in the third direction x is not limited in this application. For example, a thickness range of the second P-type semiconductor region in the third direction may be less than 1 µm. For example, the thickness range of the second P-type semiconductor region in the third direction may be 0.3 µm to 0.8 µm.

For example, when the SiC MOSFET provided in this embodiment of this application is used in a power conversion circuit, the source of the SiC MOSFET may be grounded, and the drain of the SiC MOSFET may be connected to another element. In this case, the voltage of the source of the SiC MOSFET is a ground voltage (0 V). Because the second P-type semiconductor region is connected to the source, the voltage of the second P-type semiconductor region is also a ground voltage, so that the electric field of the gate dielectric layer at the bottom of the gate trench can be effectively shielded, and working robustness of the device is improved.

For example, when the SiC MOSFET provided in this embodiment of this application is used in the power conversion circuit, the source of the SiC MOSFET may alternatively be connected to another element, and the drain of the SiC MOSFET is also connected to another element. In this case, the voltage of the source of the SiC MOSFET is a voltage of a signal input by the another element. Because the second P-type semiconductor region is connected to the source, the voltage of the second P-type semiconductor region is also the voltage of the input signal, so that the electric field of the gate dielectric layer at the bottom of the gate trench can be effectively shielded, and working robustness of the device is improved.

In some possible implementations of this application, the first epitaxial layer further includes a third P-type semiconductor region and a fourth P-type semiconductor region. The third P-type semiconductor region is disposed on a side wall of the gate trench in the first direction, and the fourth P-type semiconductor region and the source region are disposed at a same layer. The first P-type semiconductor region, the second P-type semiconductor region, the third P-type semiconductor region, and the fourth P-type semiconductor region may be formed by doping the first epitaxial layer by using the ion implantation process. In addition, the P-type semiconductor region is mainly doped with a P-type impurity, for example, boron (B), aluminum (Al), or gallium (Ga).

For example, doping concentrations of the second P-type semiconductor region, the third P-type semiconductor region, and the fourth P-type semiconductor region are greater than a doping concentration of the first P-type semiconductor region. Optionally, the doping concentrations of the second P-type semiconductor region, the third P-type semiconductor region, and the fourth P-type semiconductor region may be the same or similar. Certainly, at least two of the doping concentrations of the second P-type semiconductor region, the third P-type semiconductor region, and the fourth P-type semiconductor region may alternatively be different. It should be noted that the doping concentrations of the second P-type semiconductor region, the third P-type semiconductor region, and the fourth P-type semiconductor region may be determined based on a requirement of an actual application environment. This is not limited herein.

In some possible implementations of this application, the third P-type semiconductor region is in contact with the second P-type semiconductor region, the fourth P-type semiconductor region is in contact with the third P-type semiconductor region, and the fourth P-type semiconductor region is in contact with the source through the contact hole. The source may be connected to the second P-type semiconductor region sequentially through the fourth P-type semiconductor region and the third P-type semiconductor region, so that the voltage loaded on the source is input to the second P-type semiconductor region sequentially through the fourth P-type semiconductor region and the third P-type semiconductor region, the electric field of the gate dielectric layer at the bottom of the gate trench can be effectively shielded, and working robustness of the device is improved.

In some possible implementations of this application, in the first direction, the gate trench has the first side wall and the second side wall that are disposed opposite to each other, and the first epitaxial layer further includes at least one third P-type semiconductor region and at least one fourth P-type semiconductor region. A first side wall and/or a second side wall of at least one gate trench is disposed with one of the at least one third P-type semiconductor region, and each third P-type semiconductor region is in contact with the second P-type semiconductor region. In addition, the fourth P-type semiconductor region and the source region are disposed at a same layer. The at least one fourth P-type semiconductor region is disposed in a one-to-one correspondence and in contact with the at least one third P-type semiconductor region. The fourth P-type semiconductor region is disposed on a side that is of a corresponding third P-type semiconductor region and that is away from the gate trench, and the fourth P-type semiconductor region is in contact with a corresponding source through the contact hole.

For example, in the first direction, the gate trench has the first side wall and the second side wall that are disposed opposite to each other. A plurality of third P-type semiconductor regions are disposed. The first side wall of each gate trench is disposed with one of the plurality of third P-type semiconductor regions, and the second side wall of each gate trench is also disposed with one of the plurality of third P-type semiconductor regions. In other words, the first side wall and the second side wall of each gate trench each are disposed with the third P-type semiconductor region. In addition, each of the third P-type semiconductor regions is in contact with the second P-type semiconductor region, so that each of the third P-type semiconductor regions is connected to the second P-type semiconductor region to perform signal transmission, and a voltage of each of the third P-type semiconductor regions is the same as the voltage of the second P-type semiconductor region.

For example, a plurality of fourth P-type semiconductor regions are also disposed, and the plurality of fourth P-type semiconductor regions are disposed in a one-to-one correspondence and in contact with the plurality of third P-type semiconductor regions. One of the plurality of fourth P-type semiconductor regions is disposed in correspondence with each of the third P-type semiconductor regions disposed on the first side wall, and the fourth P-type semiconductor region is disposed on a side that is of the third P-type semiconductor region and that is away from the first side wall of the gate trench. In addition, one of the plurality of fourth P-type semiconductor regions is also disposed in correspondence with each of the third P-type semiconductor regions disposed on the second side wall, and the fourth P-type semiconductor region is disposed on a side that is of the third P-type semiconductor region and that is away from the second side wall of the gate trench. The source may be connected to the second P-type semiconductor region sequentially through the fourth P-type semiconductor region and the third P-type semiconductor region that are disposed in correspondence with each other, so that the voltage loaded on the source is input to the second P-type semiconductor region sequentially through the fourth P-type semiconductor region and the third P-type semiconductor region, the second P-type semiconductor region has the voltage, the electric field of the gate dielectric layer at the bottom of the gate trench can be effectively shielded, and working robustness of the device is improved.

For example, in the semiconductor device provided in this embodiment of this application, a plurality of source regions are also disposed. A plurality of source regions and a plurality of fourth P-type semiconductor regions that are located at a same end of the gate trench are alternately disposed. For example, a plurality of source regions and a plurality of fourth P-type semiconductor regions that are located on first side walls of gate trenches in a same trench group are alternately disposed. In addition, a plurality of source regions and a plurality of fourth P-type semiconductor regions that are located on second side walls of gate trenches in a same trench group are alternately disposed.

A width of the fourth P-type semiconductor region in the second direction is not limited in this application. For example, the width of the fourth P-type semiconductor region in the second direction may be the same as or similar to a trench width. Certainly, the width of the fourth P-type semiconductor region in the second direction may be different from the trench width. This is not limited herein.

In some possible implementations of this application, in the third direction, the second P-type semiconductor region covers the gate trench and the third P-type semiconductor region. In other words, an orthographic projection of the second P-type semiconductor region on the semiconductor substrate not only covers orthographic projections of all gate trenches on the semiconductor substrate, but also covers orthographic projections of all third P-type semiconductor regions on the semiconductor substrate.

In some possible implementations of this application, the second P-type semiconductor region may be a planar region extending in the second direction. In addition, a shape of the second P-type semiconductor region is not limited in this application. For example, the shape of the second P-type semiconductor region may be set to a rectangle.

For example, in the third direction, the orthographic projection of the second P-type semiconductor region on the semiconductor substrate further covers a gap between orthographic projections of two adjacent gate trenches on the semiconductor substrate. In other words, the orthographic projection of the second P-type semiconductor region on the semiconductor substrate further covers an orthographic projection, on the semiconductor substrate, of the gap between two adjacent gate trenches in the second direction.

Optionally, one second P-type semiconductor region is disposed in correspondence with one trench group. In other words, if one trench group is disposed, one second P-type semiconductor region that is a planar region is correspondingly disposed. If two trench groups are disposed, two second P-type semiconductor regions that are planar regions are correspondingly disposed. In addition, there is a gap between the two second P-type semiconductor regions. If a plurality of trench groups are disposed, a plurality of second P-type semiconductor regions that are planar regions are correspondingly disposed. In addition, there is a gap between every two adjacent second P-type semiconductor regions.

In the second direction, there is a trench spacing between two adjacent gate trenches. A specific value of the trench spacing is not limited in this application. For example, the trench spacing is less than 1 µm. Optionally, a range of the trench spacing is 50 nm to 0.5 µm. It should be noted that, when the trench spacing is less than 100 nm, the semiconductor device provided in this application forms a fin field effect transistor (Fin Field-Effect Transistor, Fin FET) effect, so that channel carrier mobility can be significantly improved, and the total on-resistance of the device can be further reduced.

In the first direction, the gate trench has a trench length. The trench length is not limited in this application. For example, the trench length is greater than 5 µm.

In the second direction, the gate trench has a trench width. The trench width is not limited in this application. For example, the trench width is less than 1 µm.

In the first direction, the contact hole has a contact width, so that the trench spacing is not greater than the contact width. Certainly, the trench spacing may alternatively be greater than the contact width. In actual application, the trench spacing and the contact width may be determined based on an actual application environment requirement, which is not limited herein.

A width of the source region in the second direction is not limited in this application. For example, the width of the source region in the second direction may be the same as or similar to the trench spacing. This is not limited herein.

In the semiconductor device provided in this embodiment of this application, the first P-type semiconductor regions on two side walls that are of the gate trench in the trench gate structure and that are in the second direction form channel regions of the SiC MOSFET. Therefore, the trench width is increased or the trench spacing is reduced, so that a density of a conductive channel of the SiC MOSFET device can be increased, and the total on-resistance of the SiC MOSFET device can be reduced.

In some possible implementations of this application, the semiconductor device includes an N-type semiconductor substrate, a first epitaxial layer, a plurality of gate trenches disposed at intervals, a gate, an interlayer dielectric layer, a source, and a drain. In addition, the first epitaxial layer includes a first N-type semiconductor region, a second N-type semiconductor region, a first P-type semiconductor region, source regions, a second P-type semiconductor region, third P-type semiconductor regions, and fourth P-type semiconductor regions. This embodiment is a variant of the implementations in the foregoing embodiment. The following describes only differences between this embodiment and the foregoing embodiment, and the same parts are not described herein again.

In this embodiment, there is a spacing region between the second P-type semiconductor region and a bottom of the gate trench. In other words, the second P-type semiconductor region at the bottom of the gate trench is not directly in contact with the bottom of the gate trench, but is connected to the bottom of the gate trench through the spacing region. For example, the spacing region is an N-type semiconductor region, and a doping concentration of the spacing region is the same as or similar to a doping concentration of the first N-type semiconductor region. Optionally, the spacing region may be a part of the first N-type semiconductor region.

In this embodiment of this application, the spacing region may be a flow path of a conduction current of a SiC MOSFET device, so that an area of a through-current region of the SiC MOSFET device can be increased, and total on-resistance of the SiC MOSFET device can be further reduced.

In some possible implementations of this application, the semiconductor device includes an N-type semiconductor substrate, a first epitaxial layer, a plurality of gate trenches disposed at intervals, a gate, an interlayer dielectric layer, a source, and a drain. In addition, the first epitaxial layer includes a first N-type semiconductor region, a second N-type semiconductor region, a first P-type semiconductor region, source regions, a second P-type semiconductor region, third P-type semiconductor regions, and fourth P-type semiconductor regions. This embodiment is a variant of the implementations in the foregoing embodiment. The following describes only differences between this embodiment and the foregoing embodiment, and the same parts are not described herein again.

In this embodiment, a plurality of third P-type semiconductor regions are disposed. A first side wall of each gate trench is disposed with one of the plurality of third P-type semiconductor regions, and a second side wall of each gate trench is not disposed with a third P-type semiconductor region. In other words, only the first side wall of each gate trench is disposed with the third P-type semiconductor region. In addition, each of the third P-type semiconductor regions is in contact with the second P-type semiconductor region, so that each of the third P-type semiconductor regions is connected to the second P-type semiconductor region to perform signal transmission, and a voltage of each of the third P-type semiconductor regions is the same as a voltage of the second P-type semiconductor region.

For example, a plurality of fourth P-type semiconductor regions are also disposed, and the plurality of fourth P-type semiconductor regions are disposed in a one-to-one correspondence and in contact with the plurality of third P-type semiconductor regions. One of the plurality of fourth P-type semiconductor regions is disposed in correspondence with each of the third P-type semiconductor regions disposed on the first side wall, and the fourth P-type semiconductor region is disposed on a side that is of the third P-type semiconductor region and that is away from the first side wall of the gate trench. The source may be connected to the second P-type semiconductor region sequentially through the fourth P-type semiconductor region and the third P-type semiconductor region that are disposed in correspondence with each other, so that a voltage loaded on the source is input to the second P-type semiconductor region sequentially through the fourth P-type semiconductor region and the third P-type semiconductor region, the second P-type semiconductor region has a voltage, an electric field of a gate dielectric layer at a bottom of the gate trench can be effectively shielded, and working robustness of the device is improved.

For example, the first epitaxial layer further includes fifth P-type semiconductor regions. The fifth P-type semiconductor region and the source region are disposed at a same layer. The fifth P-type semiconductor region is disposed on a side that is of the second side wall of the gate trench and that is away from the first side wall, and the fifth P-type semiconductor region is in contact with the source through a contact hole.

For example, there are a plurality of fifth P-type semiconductor regions, and the plurality of fifth P-type semiconductor regions are disposed in a one-to-one correspondence with second side walls of the plurality of gate trenches. In other words, one fifth P-type semiconductor region is disposed in a one-to-one correspondence with a second side wall of one gate trench. Optionally, a plurality of source regions and the plurality of fifth P-type semiconductor regions that are located on the second side walls of the gate trenches are alternately disposed. To be specific, a plurality of source regions and a plurality of fifth P-type semiconductor regions that are located on same side walls of the gate trenches are alternately disposed in a second direction.

For example, there are a plurality of fifth P-type semiconductor regions, and the plurality of fifth P-type semiconductor regions are disposed in a one-to-one correspondence with second side walls of the plurality of gate trenches. In other words, one fifth P-type semiconductor region is disposed in a one-to-one correspondence with a second side wall of one gate trench. Optionally, there are a plurality of source regions, and the gate trenches and the plurality of source regions are alternately disposed. To be specific, the gate trench and the source region are alternately disposed in the second direction.

Optionally, the fifth P-type semiconductor region may be formed by doping the first epitaxial layer by using an ion implantation process. In addition, the fifth P-type semiconductor region is mainly doped with a P-type impurity, for example, boron (B), aluminum (Al), or gallium (Ga). For example, a doping concentration of the fifth P-type semiconductor region may be the same as or similar to a doping concentration of the fourth P-type semiconductor region.

In this embodiment of this application, the first side wall of the gate trench is disposed with the third P-type semiconductor region, and no channel is formed.

In some possible implementations of this application, the semiconductor device includes an N-type semiconductor substrate, a first epitaxial layer, a plurality of gate trenches disposed at intervals, a gate, an interlayer dielectric layer, a source, and a drain. In addition, the first epitaxial layer includes a first N-type semiconductor region, a second N-type semiconductor region, a first P-type semiconductor region, source regions, a second P-type semiconductor region, third P-type semiconductor regions, and fourth P-type semiconductor regions. This embodiment is a variant of the implementations in the foregoing embodiment. The following describes only differences between this embodiment and the foregoing embodiment, and the same parts are not described herein again.

In this embodiment, a plurality of third P-type semiconductor regions are disposed. A first side wall of each gate trench is disposed with one of the plurality of third P-type semiconductor regions, and a second side wall of each gate trench is not disposed with a third P-type semiconductor region. In other words, only the first side wall of each gate trench is disposed with the third P-type semiconductor region. In addition, each of the third P-type semiconductor regions is in contact with the second P-type semiconductor region, so that each of the third P-type semiconductor regions is connected to the second P-type semiconductor region to perform signal transmission, and a voltage of each of the third P-type semiconductor regions is the same as a voltage of the second P-type semiconductor region.

For example, a plurality of fourth P-type semiconductor regions are also disposed, and the plurality of fourth P-type semiconductor regions are disposed in a one-to-one correspondence and in contact with the plurality of third P-type semiconductor regions. One of the plurality of fourth P-type semiconductor regions is disposed in correspondence with each of the third P-type semiconductor regions disposed on the first side wall, and the fourth P-type semiconductor region is disposed on a side that is of the third P-type semiconductor region and that is away from the first side wall of the gate trench. In this way, the source may be connected to the second P-type semiconductor region sequentially through the fourth P-type semiconductor region and the third P-type semiconductor region that are disposed in correspondence with each other, so that a voltage loaded on the source is input to the second P-type semiconductor region sequentially through the fourth P-type semiconductor region and the third P-type semiconductor region, the second P-type semiconductor region has a voltage, an electric field of a gate dielectric layer at a bottom of the gate trench can be effectively shielded, and working robustness of the device is improved.

For example, only the first side wall of the gate trench is disposed with the fourth P-type semiconductor region, and the second side wall of the gate trench is disposed with only the source region. The first P-type semiconductor region on the second side wall of the gate trench may be controlled by the first gate to form a channel, and the source region is disposed on the second side wall of the gate trench. In this way, a conduction current can be transmitted from the first P-type semiconductor region on the second side wall of the gate trench to the drain, and a flow path of the conduction current is further improved.

In some possible implementations of this application, the semiconductor device includes an N-type semiconductor substrate, a first epitaxial layer, a plurality of gate trenches disposed at intervals, a gate, an interlayer dielectric layer, a source, and a drain. In addition, the first epitaxial layer includes a first N-type semiconductor region, a second N-type semiconductor region, a first P-type semiconductor region, source regions, a second P-type semiconductor region, third P-type semiconductor regions, and fourth P-type semiconductor regions. This embodiment is a variant of the implementations in the foregoing embodiment. The following describes only differences between this embodiment and the foregoing embodiment, and the same parts are not described herein again.

For example, the plurality of gate trenches include a first gate trench and a second gate trench that communicate with each other in a first direction. The first gate trench and the second gate trench are respectively located in two adjacent trench groups. To be specific, the first gate trench is located in one of the two adjacent trench groups, the second gate trench is located in the other of the two adjacent trench groups, and the first gate trench and the second gate trench communicate with each other.

For example, in at least some gate trenches in two adjacent trench groups, gate trenches arranged in the first direction communicate with each other.

For example, the contact hole includes a plurality of contact sub-holes that are disposed at intervals, and at least one gate trench that is through is disposed between two adjacent contact sub-holes in a same contact hole. A quantity of the contact sub-holes that the contact hole is divided into is not limited in this application. For example, there may be two, three, four, or more contact sub-holes. In addition, a quantity of gate trenches that are through and that are disposed between two adjacent contact sub-holes in a same contact hole is not limited in this application. For example, there may be one, two, three, four, or more gate trenches. In this way, design freedom of the contact hole can be improved, and through-current uniformity of a SiC MOSFET device can be improved.

In some possible implementations of this application, the semiconductor device includes an N-type semiconductor substrate, a first epitaxial layer, a second epitaxial layer, a plurality of gate trenches disposed at intervals, a gate, an interlayer dielectric layer, a source, and a drain. In addition, the first epitaxial layer includes a first N-type semiconductor region, a second N-type semiconductor region, a first P-type semiconductor region, source regions, a second P-type semiconductor region, third P-type semiconductor regions, and fourth P-type semiconductor regions. This embodiment is a variant of the implementations in the foregoing embodiment. The following describes only differences between this embodiment and the foregoing embodiment, and the same parts are not described herein again.

In this embodiment, the second epitaxial layer is disposed between the first epitaxial layer (for example, the first N-type semiconductor region) and the semiconductor substrate. Because the second epitaxial layer is disposed, a thickness of the second P-type semiconductor region at the first epitaxial layer in a third direction may be set to be thicker. For example, the thickness of the second P-type semiconductor region in the third direction may be set to be greater than 1 µm.

In this embodiment, the second epitaxial layer is an N-type semiconductor region. For example, the second epitaxial layer is SiC doped with an N-type impurity. The N-type impurity is, for example, nitrogen (N), phosphorus (P), or arsenic (As). For example, a doping concentration of the second epitaxial layer is less than a doping concentration of the first N-type semiconductor region.

According to a second aspect, an embodiment of this application further provides a manufacturing method for a semiconductor device. The manufacturing method may include the following steps:
epitaxially growing a first epitaxial layer on an N-type semiconductor substrate; etching the first epitaxial layer to form a plurality of gate trenches that are disposed at intervals and that extend to the first epitaxial layer in a third direction perpendicular to a plane on which the semiconductor substrate is located, where the plurality of gate trenches extend in a first direction parallel to the plane on which the semiconductor substrate is located, the plurality of gate trenches are arranged in a second direction parallel to the plane on which the semiconductor substrate is located, and the first direction, the second direction, and the third direction are set in a cross manner;
forming a gate dielectric layer in the gate trench;
forming, in the gate trench in which the gate dielectric layer is formed, a first gate of a gate, and forming, on top of the first epitaxial layer, a second gate of the gate, where the first gate and the second gate are in contact with each other;
forming, on the gate, an interlayer dielectric layer that covers the entire first epitaxial layer;
etching the interlayer dielectric layer to form contact holes extending in the second direction, where the contact hole exposes a partial region of the first epitaxial layer, and an orthographic projection of the contact hole on the semiconductor substrate does not overlap an orthographic projection of the gate on the semiconductor substrate; and
forming a source on a side that is of the interlayer dielectric layer and that is away from the semiconductor substrate, where the source is in contact with the source region through the contact hole, and forming a drain on a side that is of the semiconductor substrate and that is away from the first epitaxial layer.

In some possible implementations, to form the first epitaxial layer, the epitaxially growing a first epitaxial layer on an N-type semiconductor substrate may include the following steps:

First, a first epitaxial layer that reaches a first specified thickness (that is, a thickness in the third direction) is epitaxially grown on the N-type SiC semiconductor substrate. For example, a SiC material doped with an N-type impurity is epitaxially grown on the N-type SiC semiconductor substrate by using an epitaxial growth process, to form the first epitaxial layer that reaches the first specified thickness. A specific value of the first specified thickness is not limited in this application. In actual application, the specific value of the first specified thickness may be determined based on a requirement of an actual application environment.

Then, ion implantation is performed at the first epitaxial layer by using an ion implantation process, to form a second P-type semiconductor region. For example, a P-type impurity is doped, by using the ion implantation process, in the to-be-formed second P-type semiconductor region at the first epitaxial layer, to form the second P-type semiconductor region that is a planar region. A thickness of the second P-type semiconductor region (that is, a thickness in the third direction) is not limited in this application. In actual application, a specific value of the thickness of the second P-type semiconductor region may be determined based on a requirement of an actual application environment.

Then, epitaxial growth is continued at the first epitaxial layer at which the second P-type semiconductor region is formed, until a first epitaxial layer that reaches a second specified thickness is formed. For example, the SiC material doped with the N-type impurity continues to be epitaxially grown, by using the epitaxial growth process, at the first epitaxial layer at which the second P-type semiconductor region is formed, to form the first epitaxial layer that reaches the second specified thickness.

In some possible implementations, after the epitaxially growing a first epitaxial layer on an N-type semiconductor substrate, the manufacturing method further includes the following step: performing ion implantation in a partial region of the first epitaxial layer by using the ion implantation process, to form a second N-type semiconductor region, a first P-type semiconductor region, and source regions, where a region that is of the first epitaxial layer and in which ion implantation is not performed forms a first N-type semiconductor region. For example, to form the second N-type semiconductor region, the first P-type semiconductor region, and the source regions, the region that is of the first epitaxial layer and in which ion implantation is not performed forms the first N-type semiconductor region. The performing, by using the ion implantation process, ion implantation in a partial region of the first epitaxial layer, to form a second N-type semiconductor region, a first P-type semiconductor region, and source regions, where a region that is of the first epitaxial layer and in which ion implantation is not performed forms a first N-type semiconductor region may include the following steps: The N-type impurity is doped on a surface of the first epitaxial layer by using the ion implantation process, to form the second N-type semiconductor region. Then, the P-type impurity is doped on the surface of the first epitaxial layer by using the ion implantation process, to form the first P-type semiconductor region. Then, the N-type impurity is doped on the surface of the first epitaxial layer by using the ion implantation process, to form the source regions, and the P-type impurity is doped on a surface of the first epitaxial layer that is on a first side wall and a second side wall of the gate trench, to form a fourth P-type semiconductor region disposed at a same layer as the source region. Therefore, in this embodiment of this application, after the ion implantation process is performed, the partial region of the first epitaxial layer forms the second N-type semiconductor region, the first P-type semiconductor region, the source regions, and the fourth P-type semiconductor region, and the region that is of the first epitaxial layer and in which ion implantation is not performed by using the ion implantation process forms the first N-type semiconductor region.

In some possible implementations, to form the gate trench, etching the first epitaxial layer until the first N-type semiconductor region is etched, to form, at the first epitaxial layer, the plurality of gate trench disposed at intervals may include the following steps: First, a trench mask is formed at the first epitaxial layer (where the trench mask may be a mask formed by using photoresist or a hard mask plate). A region that is of the first epitaxial layer and that forms the gate trench is covered with the trench mask, and a region that is of the first epitaxial layer and that needs to form the gate trench is exposed. Then, an appropriate etching process is selected from a plasma etching process, an ion sputtering etching process, a reactive ion etching process, and the like, to etch the region that is of the first epitaxial layer and that is not covered with the trench mask, and stop etching when the first N-type semiconductor region is etched and the second P-type semiconductor region is exposed, to form, at the first epitaxial layer, the plurality of gate trenches that extend in the first direction and are arranged in the second direction.

In some possible implementations, after the etching the first epitaxial layer until the first N-type semiconductor region is etched, to form, at the first epitaxial layer, the plurality of gate trench disposed at intervals, and before the forming a gate dielectric layer in the gate trench, the manufacturing method further includes the following step: separately forming, on a first side wall and a second side wall of each gate trench in the first direction by using a tilted ion implantation process, a third P-type semiconductor region in contact with the second P-type semiconductor region. For example, to form the third P-type semiconductor region, the separately forming, by using a tilted ion implantation process and on a first side wall and a second side wall of each gate trench in the first direction, a third P-type semiconductor region in contact with the second P-type semiconductor region may include the following steps: The P-type impurity is doped on surfaces of the first side wall and the second side wall of each gate trench by using the tilted ion implantation process, to separately form the third P-type semiconductor region in contact with the second P-type semiconductor region.

In some possible implementations, to form the gate dielectric layer, the forming a gate dielectric layer in the gate trench may include the following steps: Oxidation processing is performed at the entire first epitaxial layer by using an oxidation process, so that the gate dielectric layer is formed on the surface of the first epitaxial layer. To be specific, the gate dielectric layer is formed on a surface of each gate trench, and the gate dielectric layer is also formed on a side that is of the first epitaxial layer and that is away from the semiconductor substrate.

In some possible implementations, to form a gate, the forming, in the gate trench in which the gate dielectric layer is formed, a first gate of a gate, and forming, on top of the first epitaxial layer, a second gate of the gate, where the first gate and the second gate are in contact with each other may include the following steps: First, a polycrystalline silicon material is deposited, by using a deposition process, at the entire first epitaxial layer at which the gate trench is formed, so that the polycrystalline silicon material is filled in the gate trench, and the entire first epitaxial layer is covered with a polycrystalline silicon material film layer after the gate trench is filled with the polycrystalline silicon material. Then, a gate mask is formed at the first epitaxial layer (where the gate mask may be a mask formed by using photoresist or a hard mask plate). A region that forms the second gate is covered with the gate mask, and other regions are exposed. Then, an appropriate etching process is selected from a plasma etching process, an ion sputtering etching process, a reactive ion etching process, and the like, to etch a polycrystalline silicon material region that is not covered with the trench mask, and stop etching when the source region and the fourth P-type semiconductor region are exposed, to form the first gate and the second gate.

In some possible implementations, to form the interlayer dielectric layer, the forming, on the gate, an interlayer dielectric layer that covers the entire first epitaxial layer may include the following steps: The interlayer dielectric layer is deposited at the entire first epitaxial layer by using the deposition process, where the interlayer dielectric layer covers the entire first epitaxial layer.

In some possible implementations, to form the contact holes, the etching the interlayer dielectric layer to form contact holes extending in the second direction may include the following steps: First, a mask of the contact hole is formed at the first epitaxial layer (where the mask of the contact hole may be a mask formed by using photoresist or a hard mask plate). A region that does not need to form the contact hole is covered with the mask of the contact hole, and a region that needs to form the contact hole is exposed. Then, an appropriate etching process is selected from a plasma etching process, an ion sputtering etching process, a reactive ion etching process, and the like, to etch the region that is of the interlayer dielectric layer and that is not covered with the mask of the contact hole, expose a partial region of the source region (for example, a partial region, of the source region, that is in the first direction and that is located on two sides of the first gate), and expose parts of the fourth P-type semiconductor region that are located on the two sides of the first gate.

In some possible implementations, to form the source and the drain, the forming a source on a side that is of the interlayer dielectric layer and that is away from the semiconductor substrate, where the source is in contact, through the contact hole, with the source region, and forming a drain on a side that is of the semiconductor substrate and that is away from the first epitaxial layer may include the following steps: A metal material is deposited, by using the deposition process, on the side that is of the interlayer dielectric layer and that is away from the semiconductor substrate, to form the source. The contact hole is filled with the metal material, so that the source is in contact with the source region by using the metal material filled in the contact hole. For example, when the source is formed, the metal material may be deposited, by using the deposition process, on the side that is of the semiconductor substrate and that is away from the first epitaxial layer, to form the drain. Alternatively, after the source, the metal material may be deposited, by using the deposition process, on the side that is of the semiconductor substrate and that is away from the first epitaxial layer, to form the drain.

A material of the source and the drain is not limited in this application. For example, the material for forming the source and the drain may be a metal material. For example, the metal material may include W, Al, Ti, Cu, Mo, or Pt.

According to a third aspect, an embodiment of this application further provides a power conversion circuit. The power conversion circuit may be an alternating current-direct current conversion circuit and/or a direct current-direct current conversion circuit. The power conversion circuit may include a circuit board and one or more semiconductor devices, and the semiconductor device is connected to the circuit board. The semiconductor device may be the semiconductor device according to the first aspect or various possible designs of the first aspect, or the semiconductor device manufactured according to the second aspect or various possible designs of the second aspect. Because performance of the foregoing semiconductor device is good, performance of a power conversion circuit including the foregoing semiconductor device is also good. In addition, a problem-resolving principle of the power conversion circuit is similar to a problem-resolving principle of the foregoing semiconductor device. Therefore, for technical effects of the power conversion circuit, refer to technical effects of the foregoing semiconductor device. Repeated content is not described again.

According to a fourth aspect, an embodiment of this application further provides a vehicle, and the vehicle may include a power conversion circuit. The power conversion circuit may be the power conversion circuit according to the third aspect or various possible designs of the third aspect. Because performance of the foregoing power conversion circuit is good, circuit performance of a vehicle including the foregoing power conversion circuit is also good. In addition, a problem-resolving principle of the vehicle is similar to a problem-resolving principle of the foregoing power conversion circuit. Therefore, for technical effects of the vehicle, refer to technical effects of the foregoing power conversion circuit. Repeated content is not described again.

### BRIEF DESCRIPTION OF DRAWINGS

FIG. 1 is a diagram of a relationship between resistance of a channel region and resistance of a JFET region in a SiC MOSFET device;
FIG. 2a is a schematic diagram of a structure of an electric vehicle according to an embodiment of this application;
FIG. 2b is a schematic diagram of a structure of an electronic device according to an embodiment of this application;
FIG. 3 is a schematic diagram of a top-view structure of a semiconductor device according to an embodiment of this application;
FIG. 4 is a schematic diagram of a sectional-view structure in a tangential direction of AA' in FIG. 3;
FIG. 5 is a schematic diagram of a sectional-view structure in a tangential direction of BB' in FIG. 3;
FIG. 6 is a schematic diagram of a sectional-view structure in a tangential direction of VV' in FIG. 3;
FIG. 7 is a schematic diagram of a partial three-dimensional structure in FIG. 3;
FIG. 8 is a schematic diagram of a three-dimensional structure existing when a semiconductor device shown in FIG. 7 is not provided with an interlayer dielectric layer or a source;
FIG. 9 is a schematic diagram of a three-dimensional structure of a gate trench in a semiconductor device shown in FIG. 7;
FIG. 10 is some schematic diagrams when a semiconductor device according to an embodiment of this application generates a conduction current;
FIG. 11 is a schematic diagram of a sectional-view structure in a tangential direction of GG' in FIG. 10;
FIG. 12 is some flowcharts of a manufacturing method for a semiconductor device according to an embodiment of this application;
FIG. 13a to FIG. 13j are structural schematic diagrams of a manufacturing process of a semiconductor device according to an embodiment of this application;
FIG. 14 is a schematic diagram of a three-dimensional structure of a semiconductor device according to another embodiment of this application;
FIG. 15 is a schematic diagram of a structure of a gate trench in a semiconductor device shown in FIG. 14;
FIG. 16 is a schematic diagram of a three-dimensional structure of a semiconductor device according to still another embodiment of this application;
FIG. 17 is a schematic diagram of a three-dimensional structure existing when a semiconductor device shown in FIG. 16 is not provided with an interlayer dielectric layer or a source;
FIG. 18 is a schematic diagram of a three-dimensional structure of a gate trench in a semiconductor device shown in FIG. 16;
FIG. 19 is a schematic diagram of a three-dimensional structure of a semiconductor device according to still another embodiment of this application;
FIG. 20 is a schematic diagram of a three-dimensional structure existing when a semiconductor device shown in FIG. 19 is not provided with an interlayer dielectric layer or a source;
FIG. 21 is a schematic diagram of a three-dimensional structure of a gate trench in a semiconductor device shown in FIG. 19;
FIG. 22 is a schematic diagram of a top-view structure of a semiconductor device according to another embodiment of this application;
FIG. 23 is a schematic diagram of a three-dimensional structure of a semiconductor device according to still another embodiment of this application; and
FIG. 24 is some flowcharts of a manufacturing method for a semiconductor device according to an embodiment of this application.

### Reference numerals:

010: electric vehicle; 012: storage battery; 013: load; 0100: electronic device; 011/0110: power conversion circuit; 0120: load module; 0200: power supply; 0111: DC-DC converter; 01/01c1/01c2/01d1/01d2/01e1/01e2: gate trench; 02/021/022/023: contact hole; 02a/02b: contact sub-hole; 1: semiconductor substrate; 100: first epitaxial layer; 2: first N-type semiconductor region; 3: second N-type semiconductor region; 4: first P-type semiconductor region; 5: fourth P-type semiconductor region; 6: source region; 7: trench gate structure; 8: second P-type semiconductor region; 9: third P-type semiconductor region; 10: gate dielectric layer; 11: gate; 111: first gate; 112: second gate; 12: interlayer dielectric layer; 13: source; 14: drain; 15: fifth P-type semiconductor region; 201: second epitaxial layer; 202: spacing region; 01a: first edge trench; 01b: second edge trench; x: first direction; y: second direction; z: third direction; C: trench spacing; D: trench length; E: trench width; F: contact width; GK1/GK2: trench group; S1: first side wall; S2: second side wall; DS1: first specified thickness; DS2: second specified thickness.

### DESCRIPTION OF EMBODIMENTS

To make the objectives, technical solutions, and advantages of this application clearer, the following further describes this application in detail with reference to the accompanying drawings. A specific operation method in method embodiments may also be applied to an apparatus embodiment or a system embodiment. It should be noted that, in the description of this application, "at least one" means one or more, and "a plurality of" means two or more. In view of this, in embodiments of this application, "a plurality of" may also be understood as "at least two". The term "and/or" describes an association relationship between associated objects and indicates that three relationships may exist. For example, A and/or B may indicate the following cases: Only A exists, both A and B exist, and only B exists, where A and B may be singular or plural. In addition, the character "/", unless otherwise specified, usually indicates an "or" relationship between the associated objects. In addition, it should be understood that terms such as "first" and "second" in the description of this application are merely used for distinguishing and description, but should not be understood as indicating or implying relative importance, or should not be understood as indicating or implying a sequence.

It should be noted that "connection" in embodiments of this application means an electrical connection, and a connection of two electrical components may be a direct or indirect connection between two electrical components. For example, a connection between A and B may be either a direct connection between A and B, or an indirect connection between A and B through one or more other electrical components. For example, the connection between A and B may be that A and C are directly connected, C and B are directly connected, and A and B are connected through C.

However, example implementations may be implemented in a plurality of forms and should not be construed as being limited to implementations described herein, but instead, these implementations are provided to make this application thorough and complete, and to fully convey the concept of the example implementations to a person skilled in the art. A same reference sign denotes a same or similar structure in the drawings, and therefore repeated descriptions thereof are omitted. The words expressing a position and a direction described in this application are all described by using the accompanying drawings as an example, but changes may also be made as required, and all the changes fall within the protection scope of this application. The accompanying drawings in this application are merely used to illustrate relative positional relationships and do not represent a real scale.

It should be noted that specific details are set forth in the following description to provide a thorough understanding of this application. However, this application can be implemented in numerous other manners different from those described herein, and a person skilled in the art can make similar inferences without departing from the connotation of this application. Therefore, this application is not limited to the specific implementations disclosed below. Example implementations of this application are subsequently described in this specification, but the description is intended to describe general principles of this application and is not intended to limit the scope of this application.

To facilitate understanding of a semiconductor device, a manufacturing method, a power conversion circuit, and a vehicle that are provided in embodiments of this application, the following first describes an application scenario of the semiconductor device.

The semiconductor device provided in embodiments of this application may be used in a vehicle (for example, an electric vehicle), for example, may be used in an on-board micro controller unit (micro controller unit, MCU) or an on-board battery charger (on-board battery charger, OBC). It should be noted that the semiconductor device provided in embodiments of this application is intended to include but is not limited to being used in these devices and any other device of a proper type. The following provides descriptions by using an example in which the vehicle is an electric vehicle.

FIG. 2a is a schematic diagram of a structure of an electric vehicle according to an embodiment of this application. Refer to FIG. 2a. The electric vehicle 010 may include a power conversion circuit 011 and a storage battery 012.

In a possible implementation, the power conversion circuit 011 may include an alternating current (Alternating Current, AC)-direct current (Direct Current, DC) conversion circuit and a DC-DC conversion circuit, and the power conversion circuit 011 may also be referred to as an inverter. For example, when the electric vehicle is charged, the electric vehicle 010 may be connected to a three-phase power grid, and receive a three-phase alternating current supplied by the three-phase power grid. A power switching transistor of the AC-DC conversion circuit of the power conversion circuit 011 is controlled to work, so that the AC-DC conversion circuit can convert the three-phase alternating current into the direct current. A power switching transistor of the DC-DC conversion circuit of the power conversion circuit 011 is controlled to work, so that the DC-DC conversion circuit can perform voltage regulation on the direct current output by the AC-DC conversion circuit, to supply a voltage-adapted direct current to the storage battery 012. In this way, the storage battery 012 can store the direct current, and a function of charging can be implemented.

In another possible implementation, the power conversion circuit 011 may alternatively be the DC-DC conversion circuit, and the electric vehicle 010 may further include a load 013. The load 013 may be a vehicle-mounted device, a power system, or the like of the electric vehicle 010. For example, the power switching transistor of the DC-DC conversion circuit of the power conversion circuit 011 is controlled to work, so that the power conversion circuit 011 can perform voltage regulation on a direct current output by the storage battery and then output the direct current to the load 013, to supply the voltage-adapted direct current to the load 013.

A semiconductor device provided in embodiments of this application is a MOSFET of a trench gate structure. A density of a conduction channel can be increased, and resistance of a JFET region is not increased, so that total on-resistance is reduced, device performance is improved, and a device loss is reduced. For example, the semiconductor device provided in embodiments of this application may be used in a power conversion circuit 011 of a vehicle as a power switching transistor of an AC-DC converter and/or a DC-DC converter. Because device performance of the semiconductor device provided in embodiments of this application is good, when the semiconductor device is used in the AC-DC converter and/or the DC-DC converter, performance of the AC-DC converter and/or the DC-DC converter can be improved and a drive loss can be reduced, so that performance of the entire circuit is improved and the drive loss is reduced.

The semiconductor device provided in embodiments of this application may also be widely used in various electronic devices, for example, may be used in an electronic device having a logic device or a storage device. For example, the electronic device may be a smartphone, a smart television, a notebook computer, a personal digital assistant (personal digital assistant, PDA), a wearable device (for example, a smartwatch, smart glasses, or a smart band) having a wireless communication function, or the like. It should be noted that the semiconductor device provided in embodiments of this application is intended to include but is not limited to being used in these electronic devices and any other electronic device of a proper type.

FIG. 2b is a schematic diagram of a structure of an electronic device according to an embodiment of this application. Refer to FIG. 2b, the electronic device 0100 provided in this embodiment of this application includes a power conversion circuit 0110 and a load module 0120. The power conversion circuit 0110 is electrically connected to the load module 0120. For example, the electronic device 0100 may be any electric device. For example, the electronic device 0100 may be a smartphone, a smart television, a notebook computer, a personal digital assistant (personal digital assistant, PDA), a wearable device (for example, a smartwatch, smart glasses, or a smart band) having a wireless communication function, an on-board micro controller unit (micro controller unit, MCU), or an on-board battery charger (on-board battery charger, OBC). It should be noted that a specific type of the electronic device is not limited in this application.

In some embodiments, the power conversion circuit 0110 may be a DC-DC power conversion circuit, and is configured to output a direct current after performing boost or buck conversion processing on the direct current, to supply power to the load module 0120. For example, the power conversion circuit 0110 may convert a direct current (for example, 48 V) output by a power supply 0200 into a direct current used for all types of load modules 0120, and output the direct current to the load module 0120, so that the load module 0120 works. The power supply 0200 and the load module 0120 are not limited in this application. The power supply 0200 may be any device or component that can output a direct current. For example, the power supply 0200 may be a battery (for example, a storage battery). In this case, the power conversion circuit 0110 may receive a battery voltage supplied by the battery, convert the battery voltage into a working voltage of the load module 0120, and output the working voltage to the load module 0120. The load module 0120 may be any function module that uses a direct current. For example, the load module 0120 may be a processor, a chip, or the like.

Refer to FIG. 2a. The power conversion circuit 0110 may include a DC-DC converter 0111. In specific working, a MOSFET in the DC-DC converter 0111 works at a specific switching frequency, so that the DC-DC converter 0111 performs boost or buck conversion processing on a direct current of the power supply 0200, and then outputs the direct current, to supply a direct current of the working voltage to the load module 0120. For example, the DC-DC converter is, for example, a Buck (buck) converter, a Boost (boost) converter, a half-bridge converter, a full-bridge converter, and an inductor-inductor-capacitor (inductor-inductor-capacitor, LLC) resonant converter.

A semiconductor device provided in embodiments of this application is a MOSFET of a trench gate structure. A density of a conduction channel can be increased, and resistance of a JFET region is not increased, so that total on-resistance is reduced, device performance is improved, and a device loss is reduced. For example, the semiconductor device provided in embodiments of this application may be used in the DC-DC converter 0111 as a MOSFET in the DC-DC converter 0111. Because device performance of the semiconductor device provided in embodiments of this application is good, when the semiconductor device is used in the MOSFET in the DC-DC converter 0111, performance of the DC-DC converter 0111 can be improved and a drive loss can be reduced, so that performance of the entire electronic device is improved and the drive loss is reduced.

It should be noted that the foregoing scenario description is merely an example of some implementable application manners of the semiconductor device in this application. A specific application scenario of the semiconductor device provided in embodiments of this application is not limited in this application, and may be determined based on an actual application requirement.

In some embodiments provided in this application, materials of a semiconductor substrate and a first epitaxial layer may be SiC. In this case, the semiconductor device provided in embodiments of this application is a SiC MOSFET.

It should be noted that, in this application, at a layer with a prefix of N or P and in a region with a prefix of N or P, N or P respectively indicates that an electron or a hole is a majority carrier. In addition, "+" marked beside N or P indicates a higher doping concentration than a doping concentration of a layer or region not marked with "+", and a larger quantity of "+" indicates a higher doping concentration. In addition, Ns or Ps that include a same quantity of "+" indicate similar doping concentrations not limited to a same doping concentration. In addition, "-" marked beside N or P indicates a lower doping concentration than a doping concentration of a layer or region not marked with "-", and a larger quantity of "-" indicates a lower doping concentration. Ns or Ps that include a same quantity of "-" indicate similar doping concentrations not limited to a same doping concentration.

In addition, it should be further noted that, in this application, a comparison between doping concentrations of two regions is merely a comparison between concentrations of impurities doped in the two regions. A component of an impurity and a material of a substrate doped with the impurity are not limited. In other words, components of the impurities may be the same or may be different. Materials of substrates doped with the impurities may be the same or may be different.

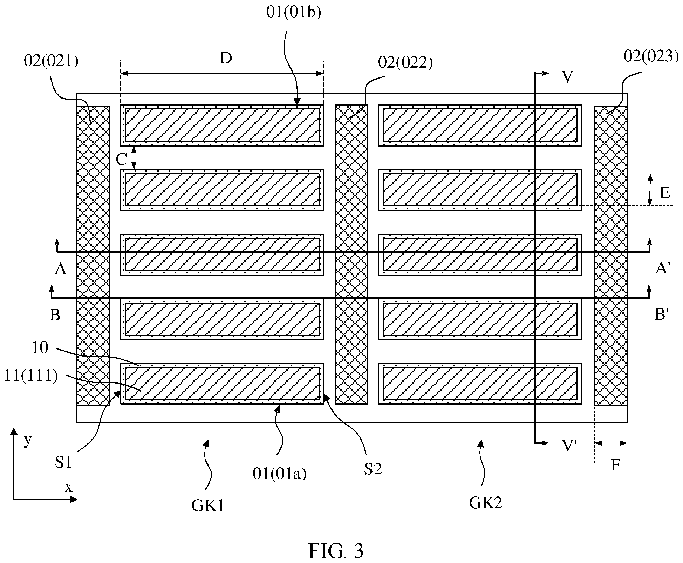

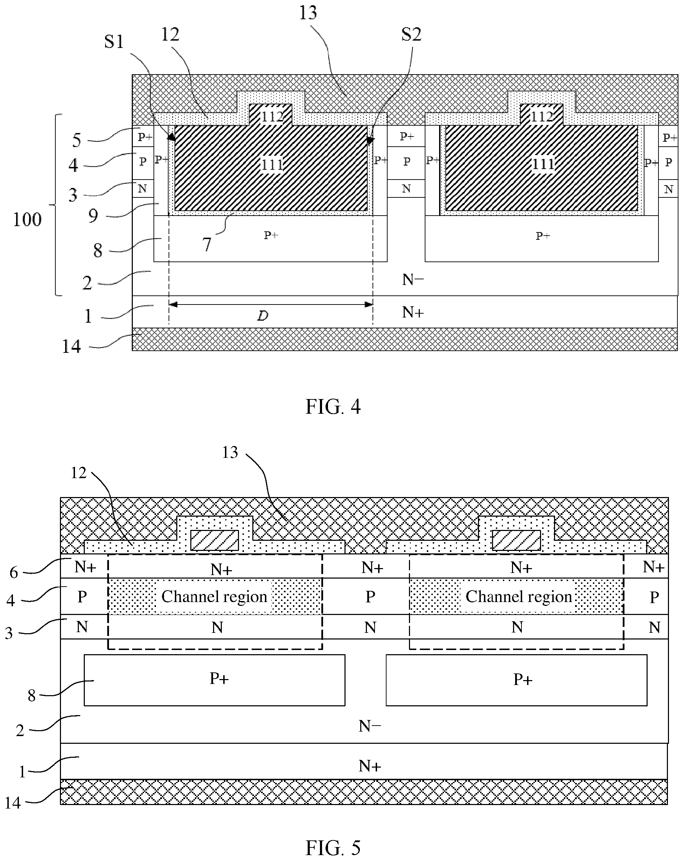

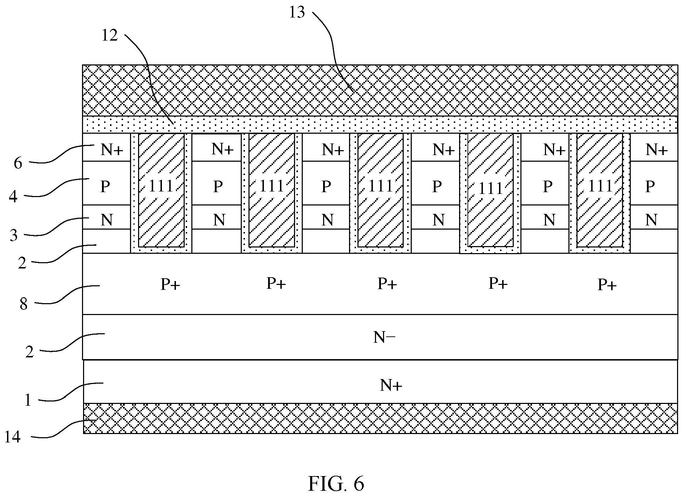

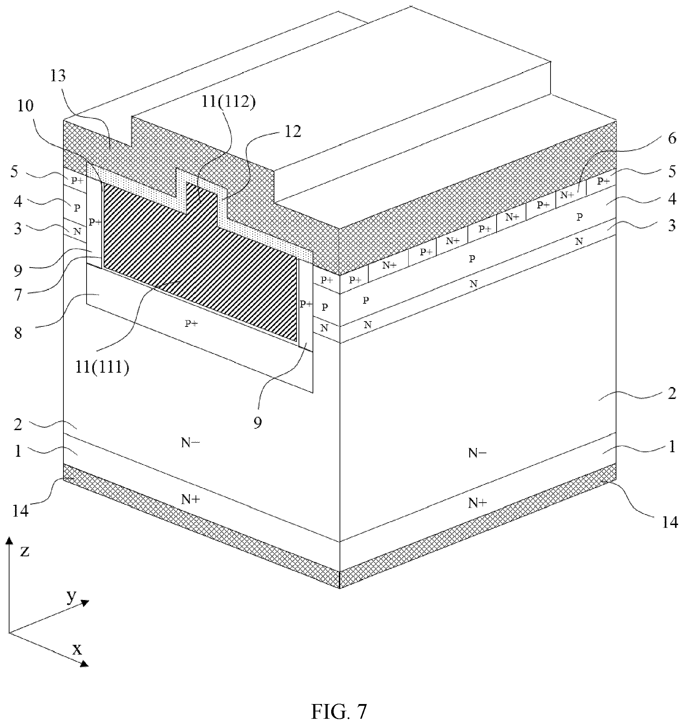

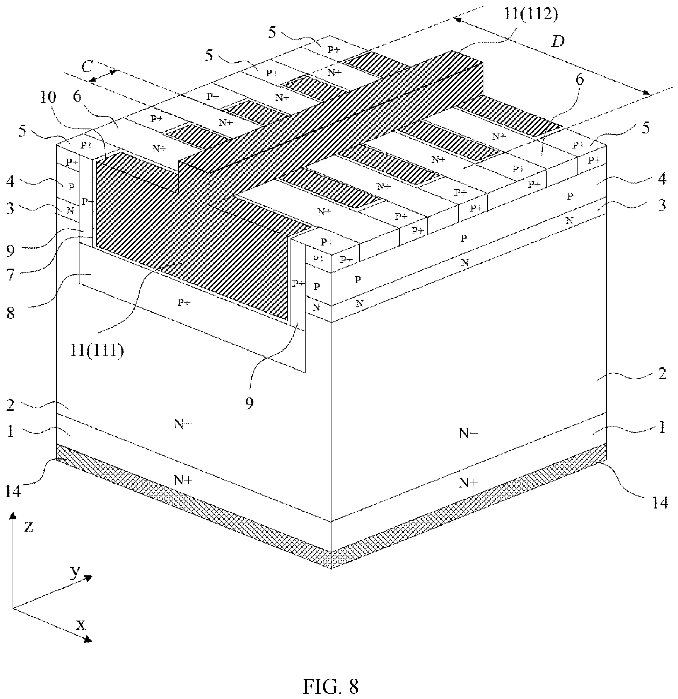

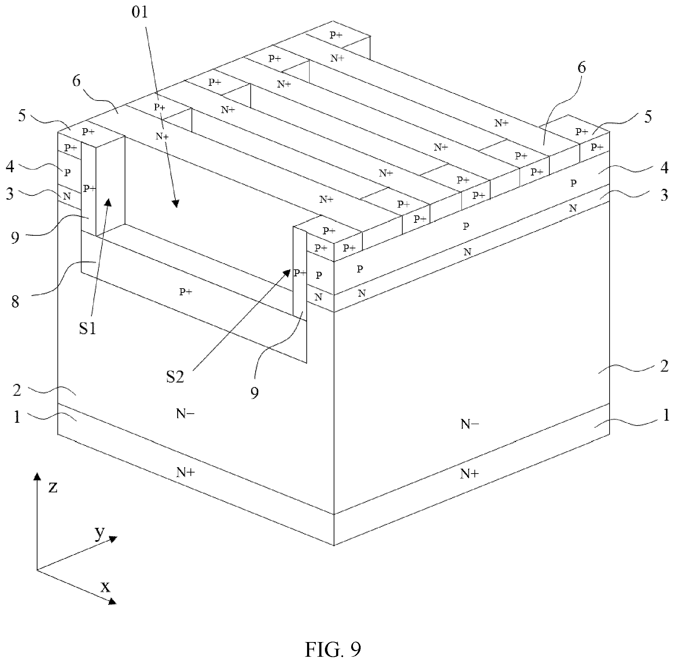

FIG. 3 shows a schematic diagram of a top-view structure of a semiconductor device according to an embodiment of this application. FIG. 4 shows a schematic diagram of a sectional-view structure in a tangential direction of AA' in FIG. 3. FIG. 5 shows a schematic diagram of a sectional-view structure in a tangential direction of BB' in FIG. 3. FIG. 6 shows a schematic diagram of a sectional-view structure in a tangential direction of VV' in FIG. 3. FIG. 7 shows a schematic diagram of a partial three-dimensional structure in FIG. 3. FIG. 8 shows a schematic diagram of a three-dimensional structure existing when the semiconductor device shown in FIG. 7 is not provided with an interlayer dielectric layer or a source. FIG. 9 shows a schematic diagram of a three-dimensional structure of a gate trench in the semiconductor device shown in FIG. 7.

Refer to FIG. 3 to FIG. 9. The semiconductor device provided in an embodiment of this application includes an N-type semiconductor substrate 1, a first epitaxial layer 100, a plurality of gate trenches 01 disposed at intervals, a gate 11, an interlayer dielectric layer 12, a source 13, and a drain 14. The first epitaxial layer 100 is disposed on the semiconductor substrate 1, and the first epitaxial layer 100 includes a first N-type semiconductor region 2, a second N-type semiconductor region 3, a first P-type semiconductor region 4, and source regions 6. The first N-type semiconductor region 2 is disposed between the second N-type semiconductor region 3 and the semiconductor substrate 1. The first P-type semiconductor region 4 is disposed on a side that is of the first N-type semiconductor region 2 and that is away from the semiconductor substrate 1. The source region 6 is disposed on a side that is of the first P-type semiconductor region 4 and that is away from the semiconductor substrate 1.

In this application, the semiconductor substrate may be a silicon carbide single crystal substrate doped with a pentavalent element. A SiC material that is generated through epitaxial growth and that is doped with a corresponding impurity may be used for the first epitaxial layer 100. For example, the first N-type semiconductor region 2 is a partial region of the first epitaxial layer 100 formed through epitaxial growth, and the second N-type semiconductor region 3 and the source region 6 may be formed by doping the first epitaxial layer 100 by using an ion implantation process. In addition, the N-type semiconductor region is mainly doped with an N-type impurity, for example, nitrogen (N), phosphorus (P), or arsenic (As). For example, a doping concentration of the semiconductor substrate 1 is greater than a doping concentration of the second N-type semiconductor region 3. The doping concentration of the second N-type semiconductor region 3 is greater than a doping concentration of the first N-type semiconductor region 2. A doping concentration of the source region 6 is greater than the doping concentration of the second N-type semiconductor region 3.

In this application, the first P-type semiconductor region 4 may be formed by doping the first epitaxial layer 100 by using the ion implantation process. In addition, the P-type semiconductor region is mainly doped with a P-type impurity, for example, boron (B), aluminum (Al), or gallium (Ga).

Still refer to FIG. 3 to FIG. 9. The plurality of gate trenches 01 disposed at intervals are disposed at the first epitaxial layer 100, and in a third direction z perpendicular to a plane on which the semiconductor substrate 1 is located, the gate trench 01 extends to the first N-type semiconductor region 2 The plurality of gate trenches 01 extend in a first direction x parallel to the plane on which the semiconductor substrate 1 is located. The plurality of gate trenches 01 are arranged in a second direction y parallel to the plane on which the semiconductor substrate 1 is located. A tightly arranged array of the gate trenches 01 is manufactured at the first epitaxial layer 100.

Still refer to FIG. 3 to FIG. 9. The gate 11 includes a first gate 111 and a second gate 112 that are in contact with each other. The first gate 111 is filled and disposed in the gate trench 01, and is spaced apart by a gate dielectric layer 10, so that the first gate 111 is built at the first epitaxial layer 100 made of the SiC material. The second gate 112 is disposed on top of the first epitaxial layer 100 made of the SiC material, and is also spaced apart by the gate dielectric layer 10. The first gate 111 and the first P-type semiconductor region 4 form a trench gate structure 7 of a SiC MOSFET device by using the gate dielectric layer 10. In other words, the semiconductor device provided in this embodiment of this application is a SiC MOSFET of the trench gate structure.

For example, the first gate 111 is disposed in the gate trench 01, which means that the first gate 111 extends in the first direction x. The second gate 112 may be disposed to extend in the second direction y, so that a part of the second gate 112 is disposed on top of the first epitaxial layer 100 and is spaced apart by the gate dielectric layer 10, and the other part is disposed on top of the first gate 111 and is in direct contact with the first gate 111.

A material of the gate 11 is not limited in this application. For example, the material of the gate 11 may be a polycrystalline silicon material, or may be another material having a good conductive property, for example, metal (for example, W, Al, Ti, Cu, Mo, or Pt).

Still refer to FIG. 3 to FIG. 9. The interlayer dielectric layer 12 covers a side that is of the gate 11 and that is away from the semiconductor substrate 1. In other words, the interlayer dielectric layer 12 covers a side that is of the entire semiconductor substrate 1 and that has the gate 11. The source 13 is disposed on a side that is of the interlayer dielectric layer 12 and that is away from the semiconductor substrate 1. In other words, the source 13 covers the entire interlayer dielectric layer 12. The drain 14 is disposed on a side that is of the semiconductor substrate 1 and that is away from the first epitaxial layer 100. In other words, the drain 14 covers a side that is of the semiconductor substrate 1 and on which the first epitaxial layer 100 is not disposed. In actual application, if a signal needs to be transmitted between the source 13 and the drain 14, contact holes 02 extending in the second direction y may be disposed at the interlayer dielectric layer 12. To avoid contact between the source 13 and the gate 11, an orthographic projection of the contact hole 02 on the semiconductor substrate 1 does not overlap an orthographic projection of the gate 11 on the semiconductor substrate 1. In other words, in the third direction, the contact hole 02 is disposed without overlapping the gate 11. In addition, the contact hole 02 exposes a partial region of the source region 6. For example, the contact hole 02 exposes a partial region, of the source region 6, that is located on two sides of the first gate 111 and that is in the first direction x, so that the source 13 can be in contact with the source region 6 through the contact hole 02, and effect of connecting the source 13 to the source region 6 is implemented. When the gate 11 controls the channel to be conducted, a signal may be transmitted between the source 13 and the drain 14.

A material for forming the interlayer dielectric layer 12 is not limited in this application. For example, the material for forming the interlayer dielectric layer 12 may be a dielectric material. The dielectric material includes but is not limited to silicon dioxide (SiO₂), silicon nitride (SiNO), silicon carbon oxide (SiCO), silicon nitride (SiNx), and the like.

A material for forming the source 13 and the drain 14 is not limited in this application. For example, the material for forming the source 13 and the drain 14 may be a metal material. For example, the metal material may include W, Al, Ti, Cu, Mo, or Pt.

Still refer to FIG. 3 to FIG. 9. The first direction x, the second direction y, and the third direction z are set in a cross manner. For example, the first direction x, the second direction y, and the third direction z are set to be perpendicular to each other.

According to the semiconductor device provided in this embodiment of this application, a first side wall S1 and a second side wall S2 of the gate trench 01 each are disposed with a third P-type semiconductor region 9, so that the first P-type semiconductor region 4 (that is, the first P-type semiconductor region 4 below the fourth P-type semiconductor region 5) disposed on the first side wall S1 and the second side wall S2 of the gate trench 01 is not controlled by the first gate 111 and does not have performance of a channel. Therefore, in the second direction y, a part of a side wall of the gate trench 01 that corresponds to the first gate 111 is a channel.

According to the semiconductor device provided in this embodiment of this application, the tightly arranged array of the gate trenches is manufactured at the first epitaxial layer, and the first gate is disposed in the gate trench. In the second direction, parts of two side walls of the gate trench that corresponds to the first gate are channels. In addition, an extension direction of the contact hole disposed at the interlayer dielectric layer is the second direction, and an extension direction of the gate trench (or the first gate) is the first direction. In this case, the extension direction of the contact hole is perpendicular to the extension direction of the gate trench (or the first gate). In other words, the contact hole is disposed in a direction perpendicular to the gate trench (or the first gate). Therefore, in comparison with a manner, in a conventional technology, in which the gate trench is disposed in parallel to the contact hole, according to the semiconductor device provided in this embodiment of this application, a limitation imposed by the contact hole on a trench spacing C between adjacent gate trenches in the second direction is reduced, so that the gate trench can be manufactured more tightly. In other words, the first gate is also tighter. Therefore, an array density of the gate trench of the semiconductor device provided in this embodiment of this application may be far higher than an array density of a gate trench of a device structure in a conventional technology. Therefore, a channel density of the SiC MOSFET is increased, total on-resistance of the device is clearly reduced, device performance is improved, and a device loss is reduced.

In some embodiments of this application, the plurality of gate trenches in the semiconductor device may be divided into one or more trench groups, and two or more contact holes are disposed. In addition, one trench group is disposed between two adjacent contact holes, and the contact hole spans across the trench group in the second direction, so that signals evenly flow. For example, refer to FIG. 3 to FIG. 5. The plurality of gate trenches 01 in the semiconductor device are divided into two trench groups, and the two trench groups are respectively a trench group GK1 and a trench group GK2. In addition, three contact holes 02 are disposed, and the three contact holes 02 are respectively a contact hole 021, a contact hole 022, and a contact hole 023. The trench group GK1 is disposed between the contact hole 021 and the contact hole 022, and the trench group GK2 is disposed between the contact hole 022 and the contact hole 023. Alternatively, the plurality of gate trenches 01 in the semiconductor device are divided into one trench group, for example, a trench group GK1. In addition, two contact holes 02 are disposed. For example, the two contact holes 02 are respectively a contact hole 021 and a contact hole 022. The trench group GK1 is disposed between the contact hole 021 and the contact hole 022.

In some embodiments of this application, quantities of gate trenches in different trench groups may be the same. In this way, the gate trenches can be evenly distributed. For example, refer to FIG. 3. The trench group GK1 and the trench group GK2 each are disposed with five gate trenches 01. It should be noted that the quantity of gate trenches 01 disposed in the trench group GK1 and the trench group GK2 shown in FIG. 3 is merely for explanation and description, and is not a quantity of gate trenches 01 in an actually manufactured semiconductor device. In actual application, the quantity of gate trenches 01 in the trench group may be determined based on an actual application requirement. This is not limited in this application.

In some embodiments of this application, alternatively, quantities of gate trenches 01 in some trench groups may be the same, and quantities of gate trenches 01 in the other trench groups may be different. Alternatively, quantities of gate trenches 01 in different trench groups may be different. In actual application, the quantity of gate trenches 01 in the trench group may be determined based on an actual application requirement. This is not limited in this application.

In some embodiments of this application, in the second direction, two gate trenches that are located at edges of the trench group are respectively defined as a first edge trench and a second edge trench, and the contact hole extends, in the second direction, from a side that is of the first edge trench and that is away from the second edge trench to a side that is of the second edge trench and that is away from the first edge trench. For example, refer to FIG. 5. The trench group GK1 is used as an example. In the second direction, two gate trenches 01 at edges of the trench group GK1 are respectively defined as a first edge trench 01a and a second edge trench 01b, and the contact hole 02 extends, in the second direction y, from a side that is of the first edge trench 01a and that is away from the second edge trench 01b to a side that is of the second edge trench 01b and that is away from the first edge trench 01a. In this case, the contact hole 02 spans across the trench group. The contact hole 02 is a continuous opening, and gate trenches 01 in different trench groups do not communicate with each other.

The semiconductor device provided in this embodiment of this application is a SiC MOSFET device of the trench gate structure. In the SiC MOSFET device of the trench gate structure, the gate dielectric layer at a bottom and a corner of the trench gate structure 7 of the SiC MOSFET device bears extremely high electric field strength when the device works, is a weak point for electric field breakdown, and easily causes a reliability failure when the device works for a long period. Therefore, how to effectively shield the gate dielectric layer from a high electric field stress becomes a key to a high robustness/reliability design of the device. In this embodiment of this application, refer to FIG. 3 to FIG. 9. A second P-type semiconductor region 8 is further disposed at the first epitaxial layer 100. The second P-type semiconductor region 8 is disposed below the gate trench 01, and the second P-type semiconductor region 8 is disposed in direct contact with a bottom of the gate trench 01. In addition, in this application, the second P-type semiconductor region 8 may be connected to the source 13. When the SiC MOSFET device works, a voltage is loaded on the source 13. Because the second P-type semiconductor region 8 is connected to the source 13, the voltage loaded on the source 13 is input to the second P-type semiconductor region 8, so that the second P-type semiconductor region 8 also has a corresponding voltage, an electric field of the gate dielectric layer at the bottom of the gate trench 01 can be effectively shielded, and working robustness of the device is improved.

A thickness of the second P-type semiconductor region 8 in the third direction x is not limited in this application. For example, a thickness range of the second P-type semiconductor region 8 in the third direction may be less than 1 µ. For example, the thickness range of the second P-type semiconductor region 8 in the third direction may be 0.3 µ to 0.8 µm.

For example, when the SiC MOSFET provided in this embodiment of this application is used in a power conversion circuit, the source of the SiC MOSFET may be grounded, and the drain of the SiC MOSFET may be connected to another element. In this case, the voltage of the source of the SiC MOSFET is a ground voltage (0 V). Because the second P-type semiconductor region is connected to the source, the voltage of the second P-type semiconductor region is also a ground voltage, so that the electric field of the gate dielectric layer at the bottom of the gate trench can be effectively shielded, and working robustness of the device is improved.

For example, when the SiC MOSFET provided in this embodiment of this application is used in the power conversion circuit, the source of the SiC MOSFET may alternatively be connected to another element, and the drain of the SiC MOSFET is also connected to another element. In this case, the voltage of the source of the SiC MOSFET is a voltage of a signal input by the another element. Because the second P-type semiconductor region is connected to the source, the voltage of the second P-type semiconductor region is also the voltage of the input signal, so that the electric field of the gate dielectric layer at the bottom of the gate trench can be effectively shielded, and working robustness of the device is improved.

In some embodiments of this application, refer to FIG. 3, FIG. 4, and FIG. 7 to FIG. 9. The first epitaxial layer 100 further includes third P-type semiconductor regions 9 and fourth P-type semiconductor regions 5. The third P-type semiconductor region 9 is disposed on a side wall of the gate trench 01 in the first direction, and the fourth P-type semiconductor region 5 and the source region 6 are disposed at a same layer. The first P-type semiconductor region 4, the second P-type semiconductor region 8, the third P-type semiconductor region 9, and the fourth P-type semiconductor region 5 may be formed by doping the first epitaxial layer 100 by using an ion implantation process. In addition, the P-type semiconductor region is mainly doped with a P-type impurity, for example, boron (B), aluminum (Al), or gallium (Ga).

For example, doping concentrations of the second P-type semiconductor region 8, the third P-type semiconductor region 9, and the fourth P-type semiconductor region 5 are greater than a doping concentration of the first P-type semiconductor region 4. Optionally, the doping concentrations of the second P-type semiconductor region 8, the third P-type semiconductor region 9, and the fourth P-type semiconductor region 5 may be the same or similar. Certainly, at least two of the doping concentrations of the second P-type semiconductor region 8, the third P-type semiconductor region 9, and the fourth P-type semiconductor region 5 may be different. It should be noted that the doping concentrations of the second P-type semiconductor region 8, the third P-type semiconductor region 9, and the fourth P-type semiconductor region 5 may be determined based on a requirement of an actual application environment. This is not limited herein.

Refer to FIG. 3, FIG. 4, and FIG. 7 to FIG. 9. The third P-type semiconductor region 9 is in contact with the second P-type semiconductor region 8, the fourth P-type semiconductor region 5 is in contact with the third P-type semiconductor region 9, and the fourth P-type semiconductor region 5 is in contact with the source 13 through the contact hole 02. The source 13 may be connected to the second P-type semiconductor region 8 sequentially through the fourth P-type semiconductor region 5 and the third P-type semiconductor region 9, so that the voltage loaded on the source 13 is input to the second P-type semiconductor region 8 sequentially through the fourth P-type semiconductor region 5 and the third P-type semiconductor region 9, the electric field of the gate dielectric layer at the bottom of the gate trench 01 can be effectively shielded, and working robustness of the device is improved.

For example, refer to FIG. 3, FIG. 4, and FIG. 7 to FIG. 9. In the first direction x, the gate trench 01 has the first side wall S1 and the second side wall S2 that are disposed opposite to each other. A plurality of third P-type semiconductor regions 9 are disposed. The first side wall S 1 of each gate trench 01 is disposed with one of the plurality of third P-type semiconductor regions 9, and the second side wall S2 of each gate trench 01 is also disposed with one of the plurality of third P-type semiconductor regions 9. In other words, the first side wall S 1 and the second side wall S2 of each gate trench 01 each are disposed with the third P-type semiconductor region 9. In addition, each of the third P-type semiconductor regions 9 is in contact with the second P-type semiconductor region 8, so that each of the third P-type semiconductor regions 9 is connected to the second P-type semiconductor region 8 to perform signal transmission, and a voltage of each of the third P-type semiconductor regions 9 is the same as the voltage of the second P-type semiconductor region 8.

For example, refer to FIG. 3, FIG. 4, and FIG. 7 to FIG. 9. A plurality of fourth P-type semiconductor regions 5 are also disposed, and the plurality of fourth P-type semiconductor regions 5 are disposed in a one-to-one correspondence and in contact with the plurality of third P-type semiconductor regions 9. One of the plurality of fourth P-type semiconductor regions 5 is disposed in correspondence with the third P-type semiconductor region 9 disposed on the first side wall S1, and the fourth P-type semiconductor region 5 is disposed on a side that is of the third P-type semiconductor region 9 and that is away from the first side wall S1 of the gate trench 01. In addition, one of the plurality of fourth P-type semiconductor regions 5 is disposed in correspondence with the third P-type semiconductor region 9 disposed on the second side wall S2, and the fourth P-type semiconductor region 5 is disposed on a side that is of the third P-type semiconductor region 9 and that is away from the second side wall S2 of the gate trench 01. The source 13 is connected to the second P-type semiconductor region 8 sequentially through the fourth P-type semiconductor region 5 and the third P-type semiconductor region 9 that are disposed in correspondence with each other, so that the voltage loaded on the source 13 is input to the second P-type semiconductor region 8 sequentially through the fourth P-type semiconductor region 5 and the third P-type semiconductor region 9, the second P-type semiconductor region 8 has the voltage, the electric field of the gate dielectric layer at the bottom of the gate trench 01 can be effectively shielded, and working robustness of the device is improved.

For example, refer to FIG. 3, FIG. 4, and FIG. 7 to FIG. 9. In the semiconductor device provided in this embodiment of this application, a plurality of source regions 6 are also disposed. A plurality of source regions and a plurality of fourth P-type semiconductor regions 5 that are located at a same end of the gate trench 01 are alternately disposed. For example, a plurality of source regions 6 and a plurality of fourth P-type semiconductor regions 5 that are located on first side walls S1 of gate trenches 01 in a same trench group are alternately disposed. In addition, a plurality of source regions 6 and a plurality of fourth P-type semiconductor regions 5 that are located on second side walls S2 of gate trenches 01 in a same trench group are alternately disposed.

A width of the fourth P-type semiconductor region 5 in the second direction y is not limited in this application. For example, the width of the fourth P-type semiconductor region 5 in the second direction y may be the same as or similar to a trench width. Certainly, the width of the fourth P-type semiconductor region 5 in the second direction may be different from the trench width. This is not limited herein.

For example, refer to FIG. 3 to FIG. 9. An orthographic projection of the second P-type semiconductor region 8 on the semiconductor substrate 1 covers an orthographic projection of the gate trench 01 on the semiconductor substrate 1 and an orthographic projection of the third P-type semiconductor region 9 on the semiconductor substrate 1. In other words, in the third direction z, the second P-type semiconductor region 8 covers the gate trench 01 and the third P-type semiconductor region 9. In other words, the orthographic projection of the second P-type semiconductor region 8 on the semiconductor substrate 1 not only covers orthographic projections of all gate trenches 01 on the semiconductor substrate 1, but also covers orthographic projections of all third P-type semiconductor regions 9 on the semiconductor substrate 1.

For example, refer to FIG. 3 to FIG. 9. The second P-type semiconductor region 8 is a planar region extending in the second direction y. In addition, a shape of the second P-type semiconductor region 8 is not limited in this application. For example, the shape of the second P-type semiconductor region 8 may be set to a rectangle.

For example, refer to FIG. 3 to FIG. 9. The orthographic projection of the second P-type semiconductor region 8 on the semiconductor substrate 1 further covers a gap between orthographic projections of two adjacent gate trenches 01 on the semiconductor substrate 1. In other words, the orthographic projection of the second P-type semiconductor region 8 on the semiconductor substrate 1 further covers an orthographic projection, on the semiconductor substrate 1, of the gap between the two adjacent gate trenches 01 in the second direction y.

Optionally, refer to FIG. 3 to FIG. 9. One second P-type semiconductor region 8 is disposed in correspondence with one trench group. In other words, if one trench group is disposed, one second P-type semiconductor region 8 that is a planar region is correspondingly disposed. If two trench groups are disposed, two second P-type semiconductor regions 8 that are planar regions are correspondingly disposed. In addition, there is a gap between the two second P-type semiconductor regions 8. If a plurality of trench groups are disposed, a plurality of second P-type semiconductor regions 8 that are planar regions are correspondingly disposed. In addition, there is a gap between every two adjacent second P-type semiconductor regions 8.

Refer to FIG. 3 and FIG. 8. In the second direction y, there is a trench spacing C between two adjacent gate trenches 01. A specific value of the trench spacing C is not limited in this application. For example, the trench spacing C is less than 1 µm. Optionally, a range of the trench spacing C is 50 nm to 0.5 µm. It should be noted that, when the trench spacing C is less than 100 nm, the semiconductor device provided in this application forms a fin field effect transistor (Fin Field-Effect Transistor, Fin FET) effect, so that channel carrier mobility can be significantly improved, and the total on-resistance of the device can be further reduced.

Still refer to FIG. 3, FIG. 4, and FIG. 8. In the first direction, the gate trench 01 has a trench length D. The trench length D is not limited in this application. For example, the trench length D is greater than 5 µm.

Still refer to FIG. 3. In the second direction y, the gate trench 01 has a trench width E. The trench width E is not limited in this application. For example, the trench width is less than 1 µm.

Still refer to FIG. 3. In the first direction, the contact hole 02 has a contact width F, so that the trench spacing C is not greater than the contact width F. Certainly, the trench spacing C may alternatively be greater than the contact width F. In actual application, the trench spacing C and the contact width F may be determined based on an actual application environment requirement. This is not limited herein.

A width of the source region 6 in the second direction is not limited in this application. For example, the width of the source region 6 in the second direction y may be the same as or similar to the trench spacing C. This is not limited herein.

Refer to FIG. 5. In the semiconductor device provided in this embodiment of this application, the first P-type semiconductor regions 4 on two side walls that are of the gate trench 01 in the trench gate structure 7 and that are in the second direction y form channel regions of the SiC MOSFET. Therefore, the trench width is increased or the trench spacing C is reduced, so that a density of a conductive channel of the SiC MOSFET device can be increased, and the total on-resistance of the SiC MOSFET device can be reduced.

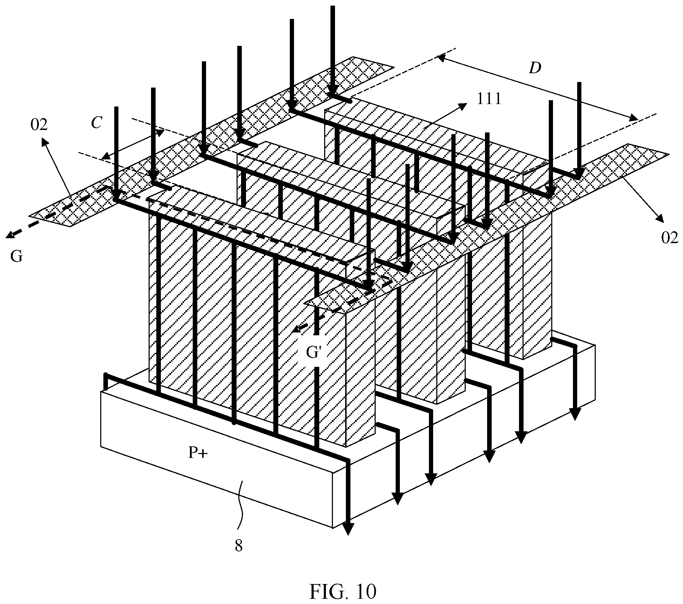

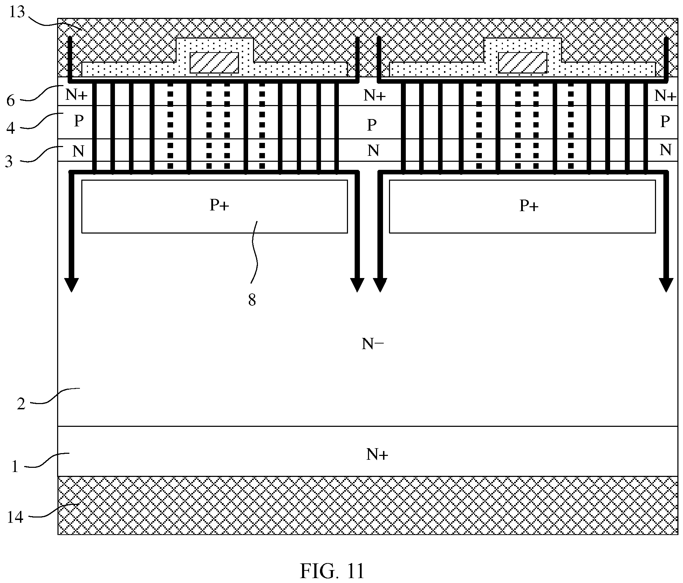

FIG. 10 shows some schematic diagrams when a semiconductor device according to an embodiment of this application generates a conduction current. FIG. 11 shows a schematic diagram of a sectional-view structure in a tangential direction of GG' in FIG. 10. Refer to FIG. 10 and FIG. 11. A black straight line with an arrow represents a flow direction of a conduction current when a SiC MOSFET is turned on. For example, when a voltage of a positive level is loaded on a gate 11 of the SiC MOSFET, the MOSFET that is of a trench gate structure and that is provided in this application may be controlled to be turned on. In this case, if different voltages are loaded on a source 13 and a drain 14 (for example, a voltage loaded on the source 13 is greater than a voltage loaded on the drain 14), the conduction current that flows from the source 13 to the drain 14 and that is shown in FIG. 10 and FIG. 11 is generated between the source 13 and the drain 14.

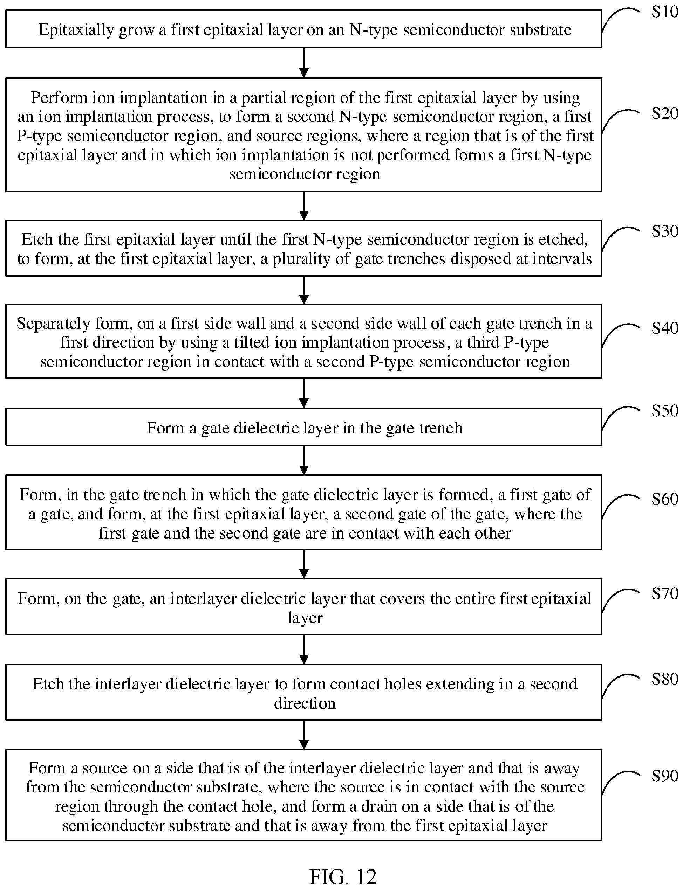

FIG. 12 shows some flowcharts of a manufacturing method for a semiconductor device according to an embodiment of this application. Refer to FIG. 12. For example, the structure shown in FIG. 7 is manufactured, and the manufacturing method may include the following steps.

S10: Epitaxially grow a first epitaxial layer on an N-type semiconductor substrate.

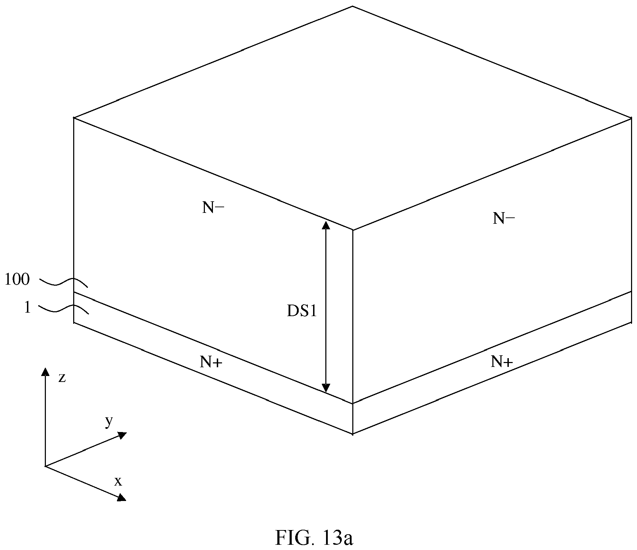

For example, step S10 includes:
First, refer to FIG. 13a. A first epitaxial layer 100 that reaches a first specified thickness DS 1 (that is, a thickness in a third direction z) is epitaxially grown on an N-type SiC semiconductor substrate 1.

For example, a SiC material doped with an N-type impurity is epitaxially grown on the N-type SiC semiconductor substrate 1 by using an epitaxial growth process, to form the first epitaxial layer 100 that reaches the first specified thickness DS1.

A specific value of the first specified thickness DS1 is not limited in this application. In actual application, the specific value of the first specified thickness DS1 may be determined based on a requirement of an actual application environment.

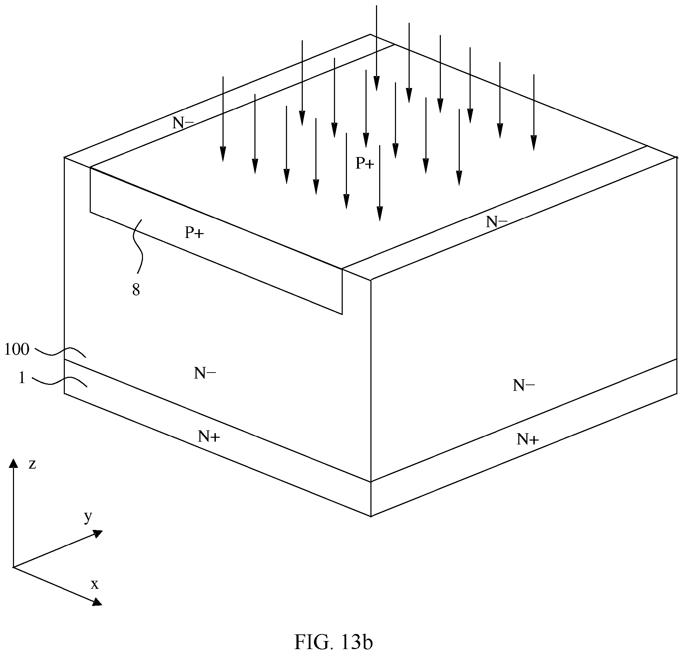

Then, refer to FIG. 13b. Ion implantation is performed at the first epitaxial layer 100 by using an ion implantation process, to form a second P-type semiconductor region 8.

For example, a P-type impurity is doped, by using the ion implantation process, in the to-be-formed second P-type semiconductor region 8 at the first epitaxial layer 100, to form the second P-type semiconductor region 8 that is a planar region.

A thickness of the second P-type semiconductor region 8 (that is, a thickness in the third direction) is not limited in this application. In actual application, a specific value of the thickness of the second P-type semiconductor region 8 may be determined based on a requirement of an actual application environment.

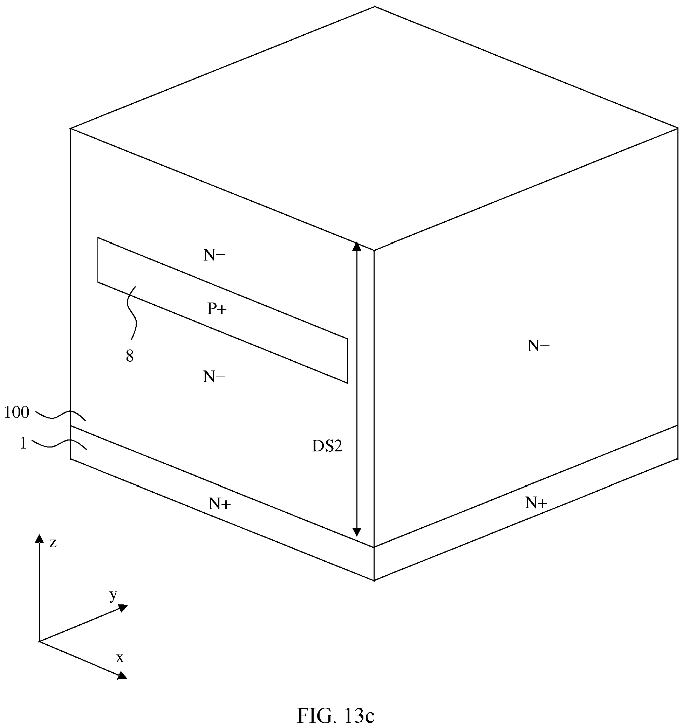

Then, refer to FIG. 13c. Epitaxial growth is continued at the first epitaxial layer 100 in which the second P-type semiconductor region 8 is formed, until a first epitaxial layer 100 that reaches a second specified thickness DS2 is formed.

For example, the SiC material doped with the N-type impurity continues to be epitaxially grown, by using the epitaxial growth process, at the first epitaxial layer 100 at which the second P-type semiconductor region 8 is formed, to form the first epitaxial layer 100 that reaches the second specified thickness DS2.

S20: Perform ion implantation in a partial region of the first epitaxial layer by using the ion implantation process, to form a second N-type semiconductor region, a first P-type semiconductor region, and source regions, where a region that is of the first epitaxial layer and in which ion implantation is not performed forms a first N-type semiconductor region.

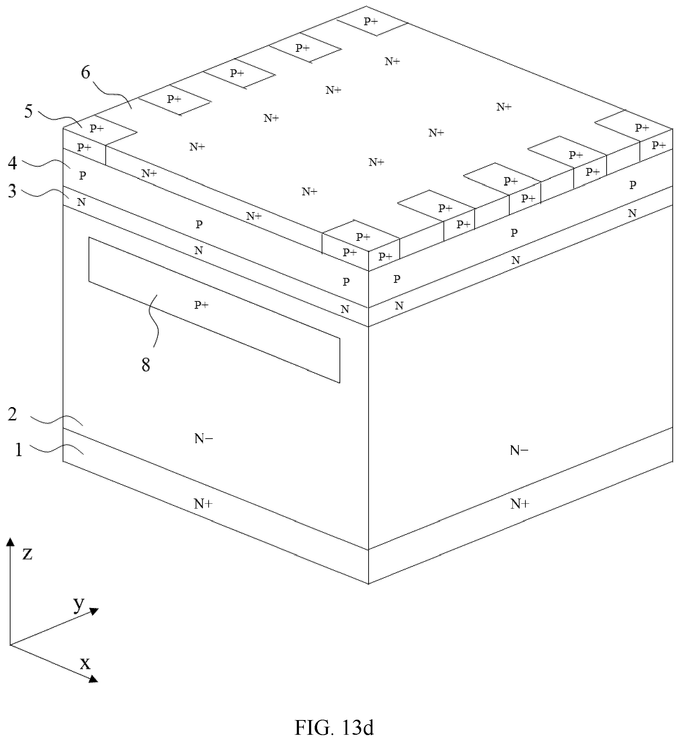

For example, refer to FIG. 13d. The N-type impurity is doped on a surface of the first epitaxial layer by using the ion implantation process, to form a second N-type semiconductor region 3. Then, the P-type impurity is doped on the surface of the first epitaxial layer by using the ion implantation process, to form a first P-type semiconductor region 4. Then, the N-type impurity is doped on the surface of the first epitaxial layer 100 by using the ion implantation process, to form source regions 6, and the P-type impurity is doped on a surface of the first epitaxial layer 100 that is on a first side wall S 1 and a second side wall S2 of a gate trench 01, to form a fourth P-type semiconductor region 5 disposed at a same layer as the source region 6.

Therefore, in this embodiment of this application, after the ion implantation process is performed, a partial region of the first epitaxial layer 100 forms the second N-type semiconductor region 3, the first P-type semiconductor region 4, the source regions 6, and the fourth P-type semiconductor region 5, and a region that is of the first epitaxial layer 100 and in which ion implantation is not performed by using the ion implantation process forms a first N-type semiconductor region 2.

S30: Etch the first epitaxial layer until the first N-type semiconductor region is etched, to form, at the first epitaxial layer, a plurality of gate trenches disposed at intervals.

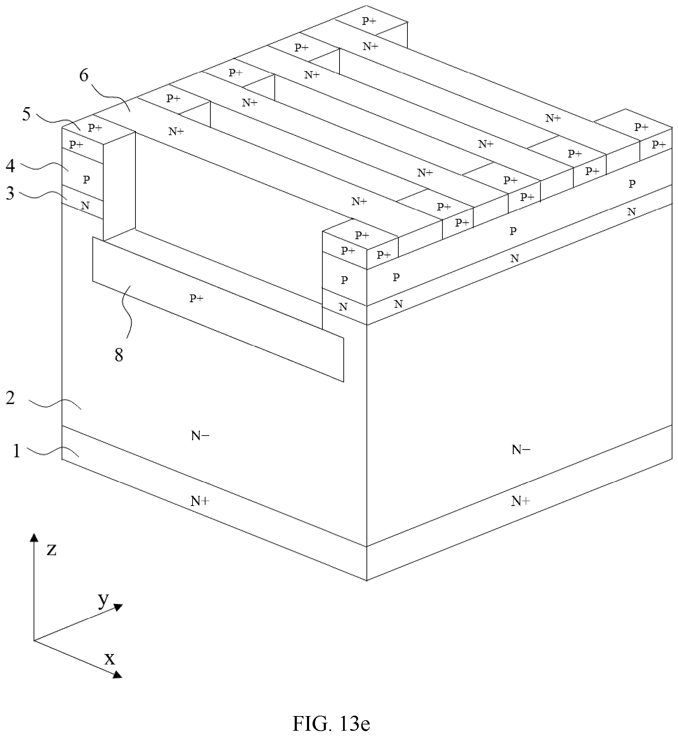

For example, first, a trench mask is formed at the first epitaxial layer (where the trench mask may be a mask formed by using photoresist or a hard mask plate). A region that is of the first epitaxial layer and that forms the gate trench 01 is covered with the trench mask, and a region that is of the first epitaxial layer and that needs to form the gate trench 01 is exposed. Then, refer to FIG. 13e. An appropriate etching process is selected from a plasma etching process, an ion sputtering etching process, a reactive ion etching process, and the like, to etch the region that is of the first epitaxial layer and that is not covered with the trench mask, and stop etching when the first N-type semiconductor region 2 is etched and the second P-type semiconductor region 8 is exposed, to form, at the first epitaxial layer, a plurality of gate trenches 01 that extend in a first direction x and are arranged in a second direction y.

S40: Separately form, on a first side wall and a second side wall of each gate trench in a first direction by using a tilted ion implantation process, a third P-type semiconductor region in contact with a second P-type semiconductor region.

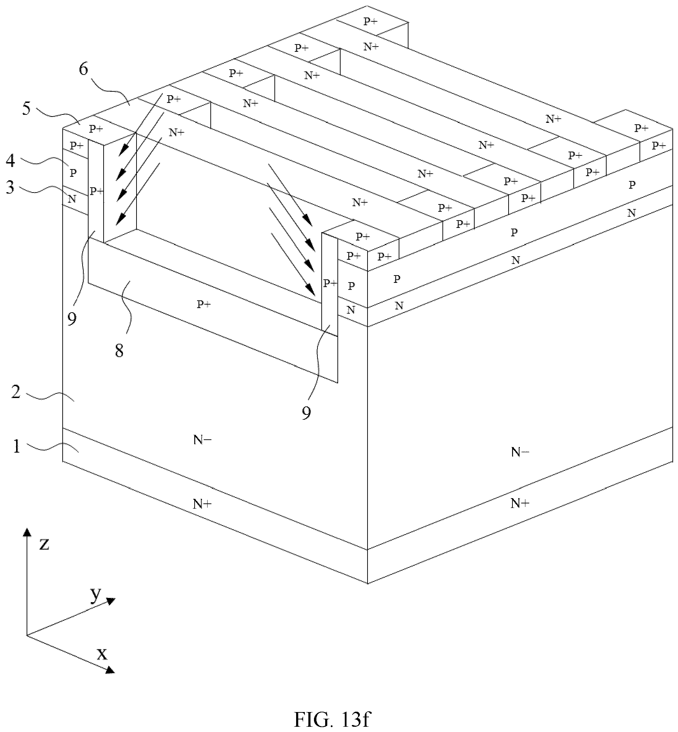

For example, refer to FIG. 13f. The P-type impurity is doped on surfaces of the first side wall S1 and the second side wall S2 of each gate trench 01 by using the tilted ion implantation process, to separately form a third P-type semiconductor region 9 in contact with the second P-type semiconductor region 8.

S50: Form a gate dielectric layer in the gate trench.

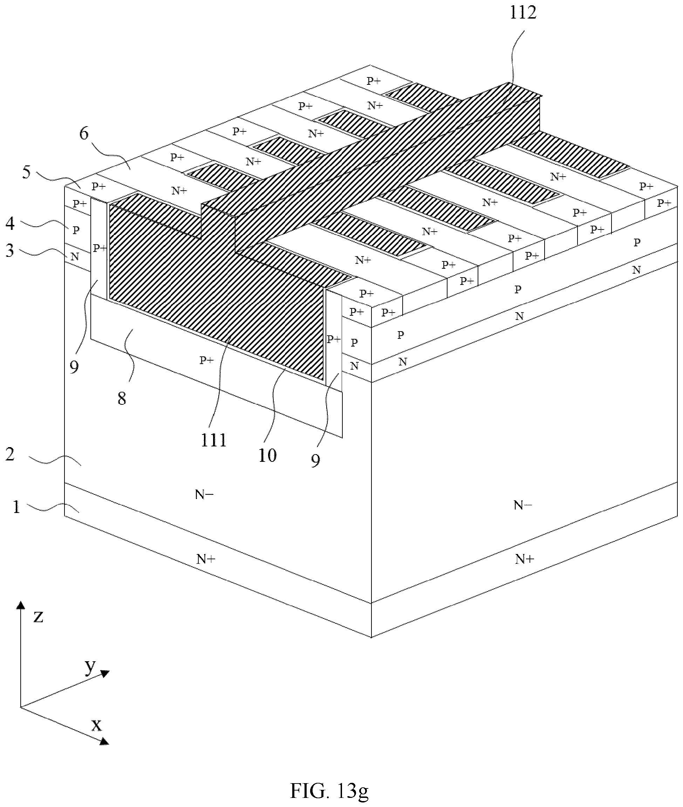

For example, refer to FIG. 13g. Oxidation processing is performed at the entire first epitaxial layer by using an oxidation process, so that a gate dielectric layer 10 is formed on the surface of the first epitaxial layer. To be specific, the gate dielectric layer 10 is formed on a surface of each gate trench 01, and the gate dielectric layer 10 is also formed on a side that is of the first epitaxial layer and that is away from the semiconductor substrate 1.

S60: Form, in the gate trench in which the gate dielectric layer is formed, a first gate of a gate, and form, at the first epitaxial layer, a second gate of the gate, where the first gate and the second gate are in contact with each other.

First, a polycrystalline silicon material is deposited, by using a deposition process, at the entire first epitaxial layer at which the gate trench is formed, so that the polycrystalline silicon material is filled in the gate trench, and the entire first epitaxial layer is covered with a polycrystalline silicon material film layer after the gate trench is filled with the polycrystalline silicon material. Then, a gate mask is formed at the first epitaxial layer (where the gate mask may be a mask formed by using photoresist or a hard mask plate). A region that forms the second gate is covered with the gate mask, and other regions are exposed. Then, refer to FIG. 13g. An appropriate etching process is selected from a plasma etching process, an ion sputtering etching process, a reactive ion etching process, and the like, to etch a polycrystalline silicon material region that is not covered with the trench mask, and stop etching when the source region 6 and the fourth P-type semiconductor region 5 are exposed, to form a first gate 111 and a second gate 112.

S70: Form, on the gate, an interlayer dielectric layer that covers the entire first epitaxial layer.

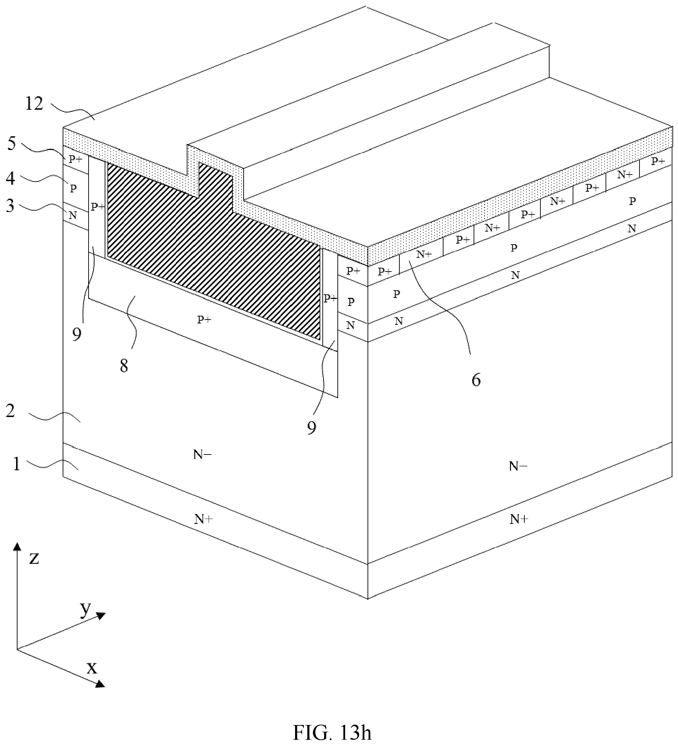

For example, refer to FIG. 13h. An interlayer dielectric layer 12 is deposited at the entire first epitaxial layer by using the deposition process, where the interlayer dielectric layer 12 covers the entire first epitaxial layer.

S80: Etch the interlayer dielectric layer to form contact holes extending in a second direction.

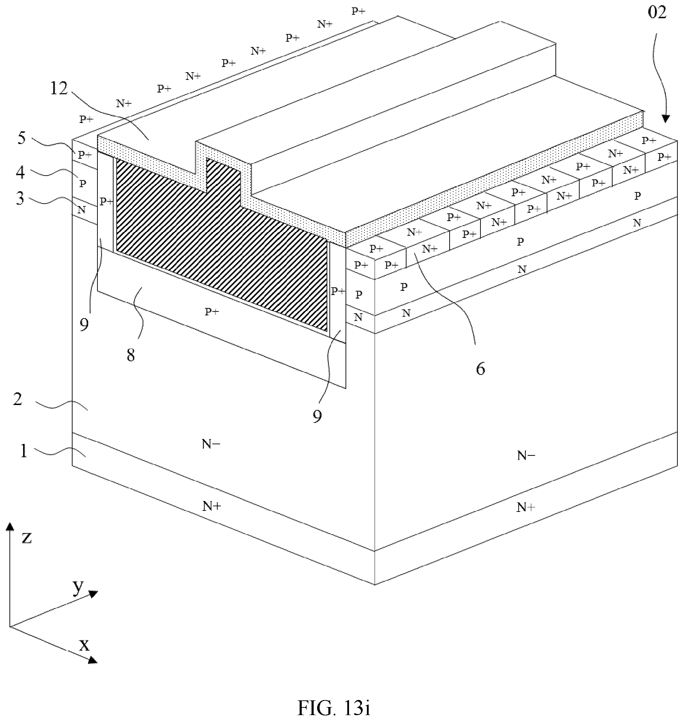

For example, first, a mask of the contact hole is formed at the first epitaxial layer (where the mask of the contact hole may be a mask formed by using photoresist or a hard mask plate). A region that does not need to form a contact hole 02 is covered with the mask of the contact hole, and a region that needs to form the contact hole 02 is exposed. Then, refer to FIG. 13i. An appropriate etching process is selected from a plasma etching process, an ion sputtering etching process, a reactive ion etching process, and the like, to etch the region that is of the interlayer dielectric layer 12 and that is not covered with the mask of the contact hole 02, expose parts of the source region 6 that are in the first direction x and that are located on two sides of the first gate 111, and expose parts of the fourth P-type semiconductor region 5 that are located on the two sides of the first gate 111.

S90: Form a source on a side that is of the interlayer dielectric layer and that is away from the semiconductor substrate, where the source is in contact with source region through the contact hole, and form a drain on a side that is of the semiconductor substrate and that is away from the first epitaxial layer.

A material of the source and the drain is not limited in this application. For example, the material for forming the source and the drain may be a metal material. For example, the metal material may include W, Al, Ti, Cu, Mo, or Pt.

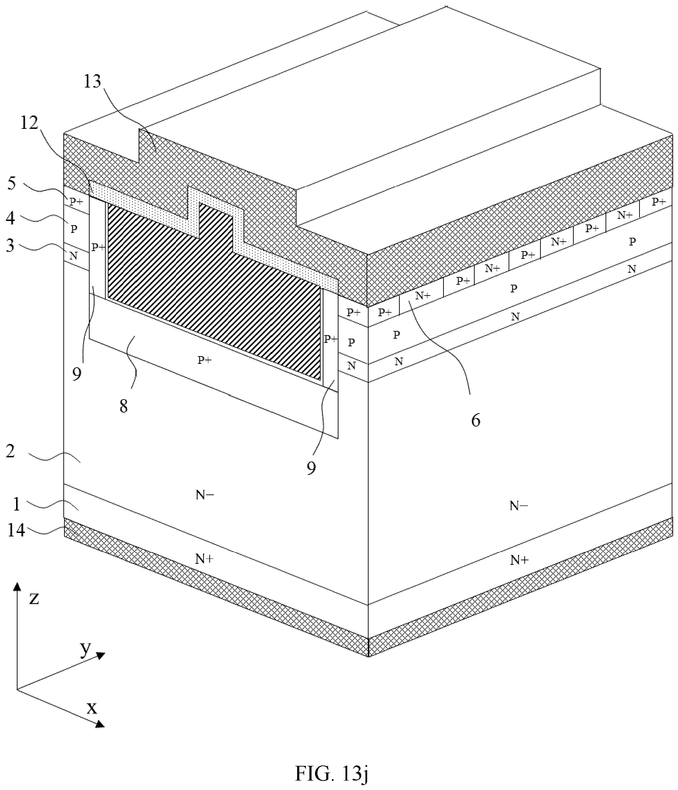

For example, refer to FIG. 13j. The metal material is deposited, by using the deposition process, on a side that is of the interlayer dielectric layer 12 and that is away from the semiconductor substrate 1, to form a source 13. The contact hole is filled with the metal material, so that the source 13 is in contact with the source region 6 by using the metal material filled in the contact hole 02.

For example, refer to FIG. 13j. When the source 13 is formed, the metal material may be deposited, by using the deposition process, on a side that is of the semiconductor substrate 1 and that is away from the first epitaxial layer, to form a drain 14. Alternatively, after the source 13, the metal material may be deposited, by using the deposition process, on a side that is of the semiconductor substrate 1 and that is away from the first epitaxial layer, to form a drain 14.

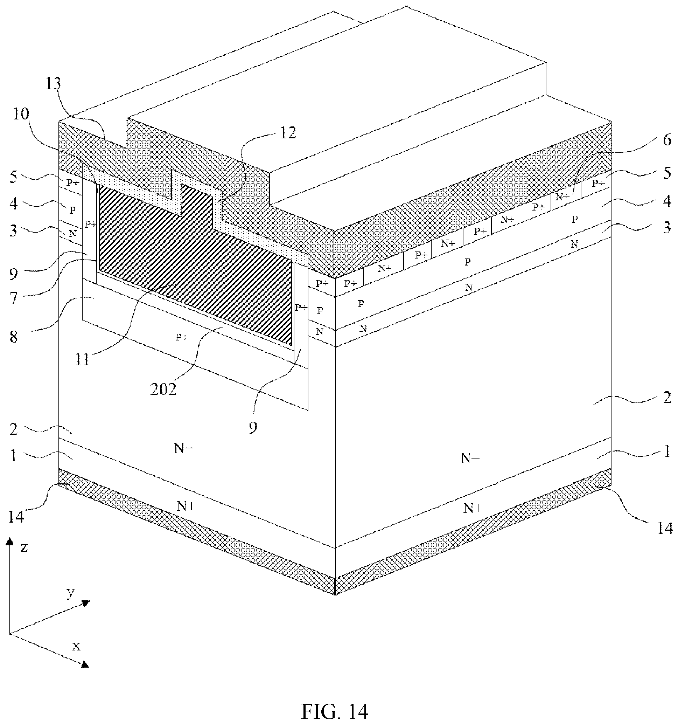

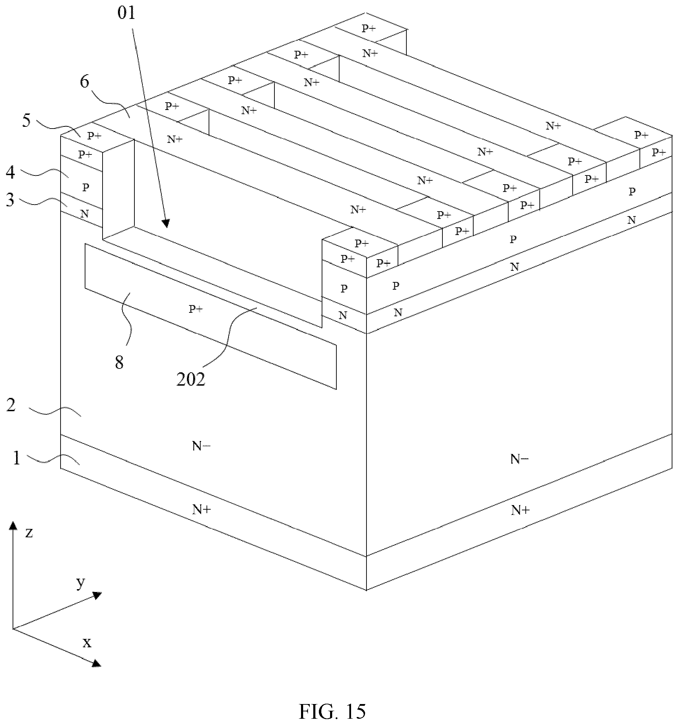

FIG. 14 shows a schematic diagram of a three-dimensional structure of a semiconductor device according to another embodiment of this application. FIG. 15 shows a schematic diagram of a structure of a gate trench in the semiconductor device shown in FIG. 14.

Refer to FIG. 14 and FIG. 15. In some other embodiments provided in this application, the semiconductor device includes an N-type semiconductor substrate 1, a first epitaxial layer, a plurality of gate trenches 01 disposed at intervals, a gate 11, an interlayer dielectric layer 12, a source 13, and a drain 14. In addition, the first epitaxial layer includes a first N-type semiconductor region 2, a second N-type semiconductor region 3, a first P-type semiconductor region 4, source regions 6, a second P-type semiconductor region 8, third P-type semiconductor regions 9, and fourth P-type semiconductor regions 5. This embodiment is a variant of the implementations in the foregoing embodiment. The following describes only differences between this embodiment and the foregoing embodiment, and the same parts are not described herein again.

Refer to FIG. 14 and FIG. 15. In this embodiment, there is a spacing region 202 between the second P-type semiconductor region 8 and a bottom of the gate trench 01. In other words, the second P-type semiconductor region 8 at the bottom of the gate trench 01 is not directly in contact with the bottom of the gate trench 01, but is connected to the bottom of the gate trench 01 through the spacing region 202. For example, the spacing region 202 is an N-type semiconductor region, and a doping concentration of the spacing region 202 is the same as or similar to a doping concentration of the first N-type semiconductor region 2. Optionally, the spacing region 202 may be a part of the first N-type semiconductor region 2.

In this embodiment of this application, the spacing region 202 may be a flow path of a conduction current of a SiC MOSFET device, so that an area of a through-current region of the SiC MOSFET device can be increased, and total on-resistance of the SiC MOSFET device can be further reduced.

For example, the structure shown in FIG. 14 is manufactured. For a flowchart of a corresponding manufacturing method, refer to FIG. 12. For steps S10 to S20 and S40 to S90, refer to the description of the foregoing manufacturing method.

In this embodiment, step S30 is as follows: Etch the first epitaxial layer until the first N-type semiconductor region is etched, to form, at the first epitaxial layer, the plurality of gate trenches 01 disposed at intervals.

In some examples, first, a trench mask is formed at the first epitaxial layer (where the trench mask may be a mask formed by using photoresist or a hard mask plate). A region that is of the first epitaxial layer and that forms the gate trench is covered with the trench mask, and a region that is of the first epitaxial layer and that needs to form the gate trench is exposed. Then, refer to FIG. 15. An appropriate etching process is selected from a plasma etching process, an ion sputtering etching process, a reactive ion etching process, and the like, to etch the region that is of the first epitaxial layer and that is not covered with the trench mask until the first N-type semiconductor region 2 is etched, and stop etching when the second P-type semiconductor region 8 is not exposed, so that a part that is of the first N-type semiconductor region 2 and that is reserved above the second P-type semiconductor region 8 forms the spacing region 202.

In some other examples, first, a trench mask is formed at the first epitaxial layer (where the trench mask may be a mask formed by using photoresist or a hard mask plate). A region that is of the first epitaxial layer and that forms the gate trench is covered with the trench mask, and a region that is of the first epitaxial layer and that needs to form the gate trench is exposed. Then, refer to FIG. 15. An appropriate etching process is selected from a plasma etching process, an ion sputtering etching process, a reactive ion etching process, and the like, to etch the region that is of the first epitaxial layer and that is not covered with the trench mask until the first N-type semiconductor region 2 is etched. According to an original design, the etching process is stopped when the second P-type semiconductor region 8 is exposed. However, due to precision limitation of the etching process, etching may be stopped when the second P-type semiconductor region 8 is not exposed. As a result, a part of the first N-type semiconductor region 2 is reserved above the second P-type semiconductor region 8, and the reserved first N-type semiconductor region 2 forms the spacing region 202.

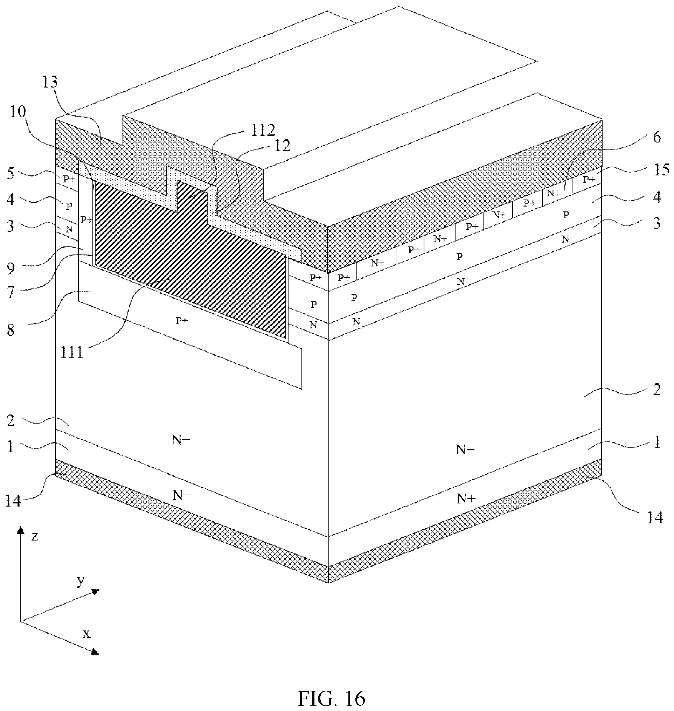

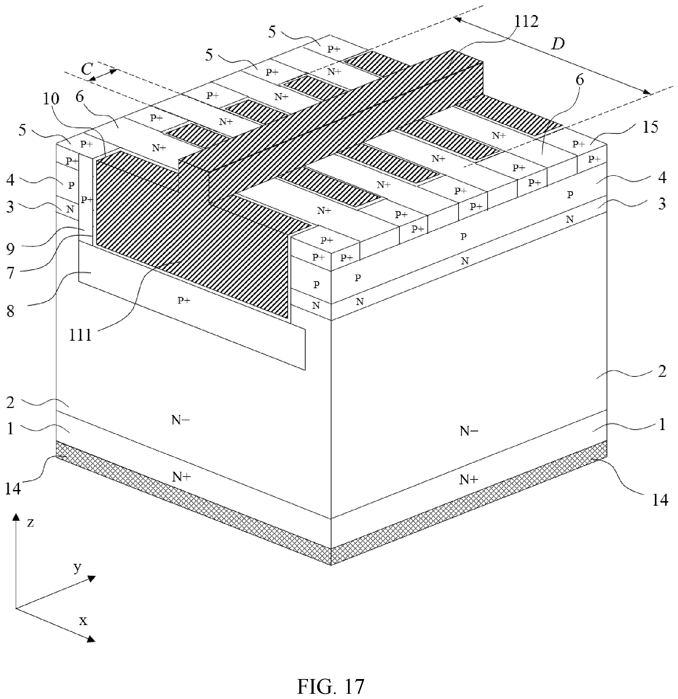

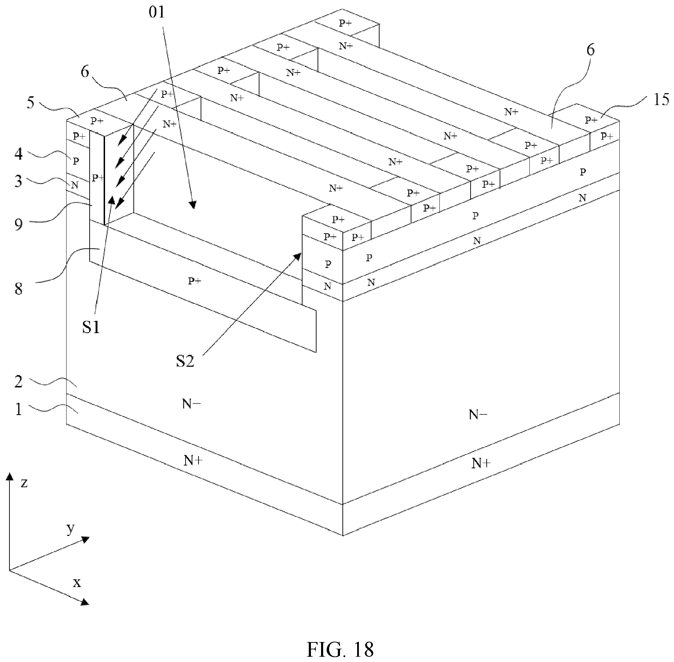

FIG. 16 shows a schematic diagram of a three-dimensional structure of a semiconductor device according to still another embodiment of this application. FIG. 17 shows a schematic diagram of a three-dimensional structure existing when the semiconductor device shown in FIG. 16 is not provided with an interlayer dielectric layer or a source. FIG. 18 shows a schematic diagram of a three-dimensional structure of a gate trench in the semiconductor device shown in FIG. 16.

Refer to FIG. 16 to FIG. 18. In still some other embodiments provided in this application, the semiconductor device provided in this embodiment of this application includes an N-type semiconductor substrate 1, a first epitaxial layer, a plurality of gate trenches 01 disposed at intervals, a gate 11, an interlayer dielectric layer 12, a source 13, and a drain 14. In addition, the first epitaxial layer includes a first N-type semiconductor region 2, a second N-type semiconductor region 3, a first P-type semiconductor region 4, source regions 6, a second P-type semiconductor region 8, third P-type semiconductor regions 9, and fourth P-type semiconductor regions 5. This embodiment is a variant of the implementations in the foregoing embodiment. The following describes only differences between this embodiment and the foregoing embodiment, and the same parts are not described herein again.

Refer to FIG. 16 to FIG. 18. In this embodiment, a plurality of third P-type semiconductor regions 9 are disposed. A first side wall S1 of each gate trench 01 is disposed with one of the plurality of third P-type semiconductor regions 9, and a second side wall S2 of each gate trench 01 is not disposed with a third P-type semiconductor region 9. In other words, only the first side wall S1 of each gate trench 01 is disposed with the third P-type semiconductor region 9. In addition, each of the third P-type semiconductor regions 9 is in contact with the second P-type semiconductor region 8, so that each of the third P-type semiconductor regions 9 is connected to the second P-type semiconductor region 8 to perform signal transmission, and a voltage of each of the third P-type semiconductor regions 9 is the same as a voltage of the second P-type semiconductor region 8.

For example, refer to FIG. 16 to FIG. 18. A plurality of fourth P-type semiconductor regions 5 are also disposed, and the plurality of fourth P-type semiconductor regions 5 are disposed in a one-to-one correspondence and in contact with the plurality of third P-type semiconductor regions 9. One of the plurality of fourth P-type semiconductor regions 5 is disposed in correspondence with the third P-type semiconductor region 9 disposed on the first side wall S1, and the fourth P-type semiconductor region 5 is disposed on a side that is of the third P-type semiconductor region 9 and that is away from the first side wall S1 of the gate trench 01. The source 13 is connected to the second P-type semiconductor region 8 sequentially through the fourth P-type semiconductor region 5 and the third P-type semiconductor region 9 that are disposed in correspondence with each other, so that a voltage loaded on the source 13 is input to the second P-type semiconductor region 8 sequentially through the fourth P-type semiconductor region 5 and the third P-type semiconductor region 9, the second P-type semiconductor region 8 has a voltage, an electric field of a gate dielectric layer at a bottom of the gate trench 01 can be effectively shielded, and working robustness of the device is improved.

For example, refer to FIG. 16 to FIG. 18. The first epitaxial layer further includes fifth P-type semiconductor regions 15. The fifth P-type semiconductor region 15 and the source region 6 are disposed at a same layer. The fifth P-type semiconductor region 15 is disposed on a side that is of the second side wall S2 of the gate trench 01 and that is away from the first side wall S1, and the fifth P-type semiconductor region 15 is in contact with the source 13 through a contact hole 02.

For example, there are a plurality of fifth P-type semiconductor regions 15, and the plurality of fifth P-type semiconductor regions 15 are disposed in a one-to-one correspondence with second side walls of the plurality of gate trenches 01. In other words, one fifth P-type semiconductor region 15 is disposed in a one-to-one correspondence with a second side wall S2 of one gate trench 01. Optionally, a plurality of source regions 6 and the plurality of fifth P-type semiconductor regions 15 that are located on the second side walls S2 of the gate trenches 01 are alternately disposed. To be specific, a plurality of source regions 6 and a plurality of fifth P-type semiconductor regions 15 that are located on same side walls of the gate trenches 01 are alternately disposed in a second direction y.

For example, a plurality of source regions are disposed, and the gate trench 01 and the plurality of source regions 6 are alternately disposed. To be specific, the gate trench 01 and the source region 6 are alternately disposed in the second direction y. To be specific, the plurality of source regions and the plurality of fifth P-type semiconductor regions 15 that are located on the second side walls S2 of the gate trenches 01 are alternately disposed.

Optionally, the fifth P-type semiconductor region 15 may be formed by doping the first epitaxial layer by using an ion implantation process. In addition, the fifth P-type semiconductor region 15 is mainly doped with a P-type impurity, for example, boron (B), aluminum (Al), or gallium (Ga). For example, a doping concentration of the fifth P-type semiconductor region 15 may be the same as or similar to a doping concentration of the fourth P-type semiconductor region 5.

In this embodiment of this application, the first side wall S1 of the gate trench 01 is disposed with the third P-type semiconductor region 9, and no channel is formed.

For example, the structure shown in FIG. 16 is manufactured. For a flowchart of a corresponding manufacturing method, refer to FIG. 12. For steps S10 to S30 and S50 to S90, refer to the description of the foregoing manufacturing method.

In this embodiment, step S40 is as follows: Separately form, on the first side wall of each gate trench in a first direction by using a tilted ion implantation process, the third P-type semiconductor region in contact with the second P-type semiconductor region.

For example, refer to FIG. 18. The P-type impurity is doped on a surface of the first side wall S1 of each gate trench 01 by using the tilted ion implantation process, to separately form the third P-type semiconductor region 9 in contact with the second P-type semiconductor region 8.

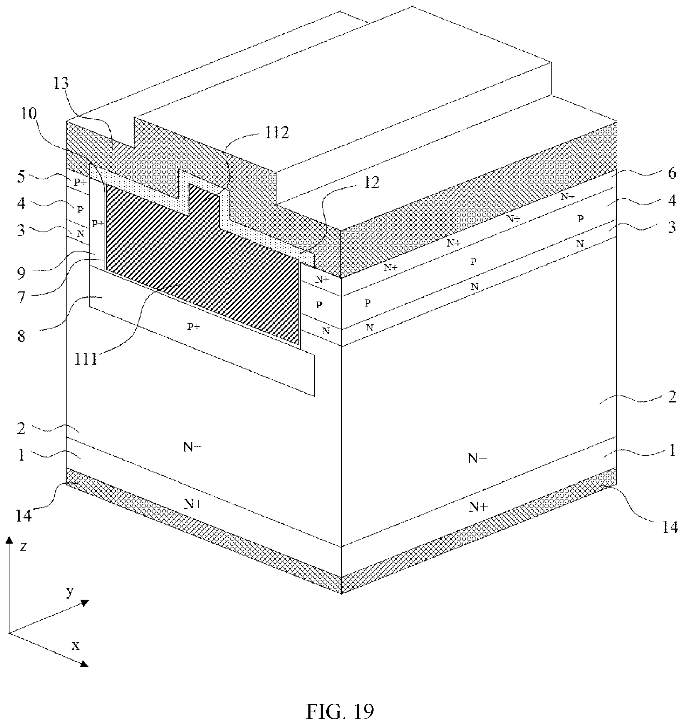

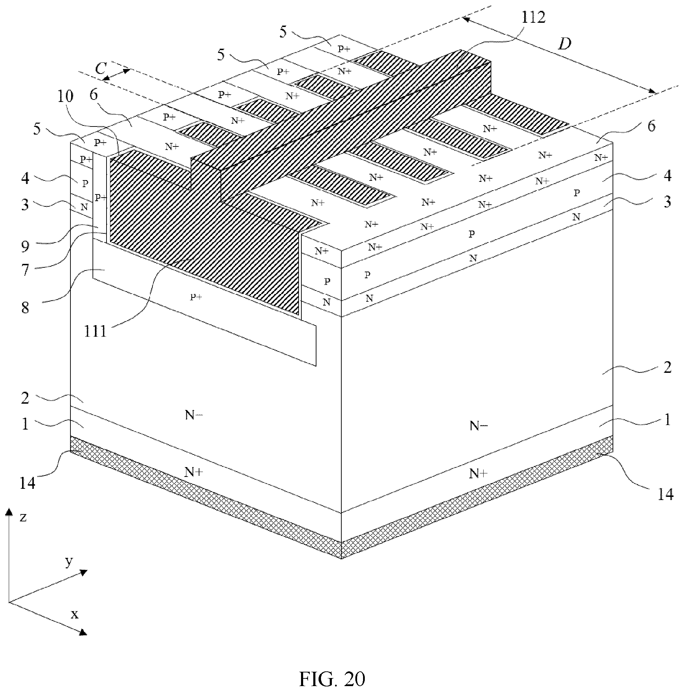

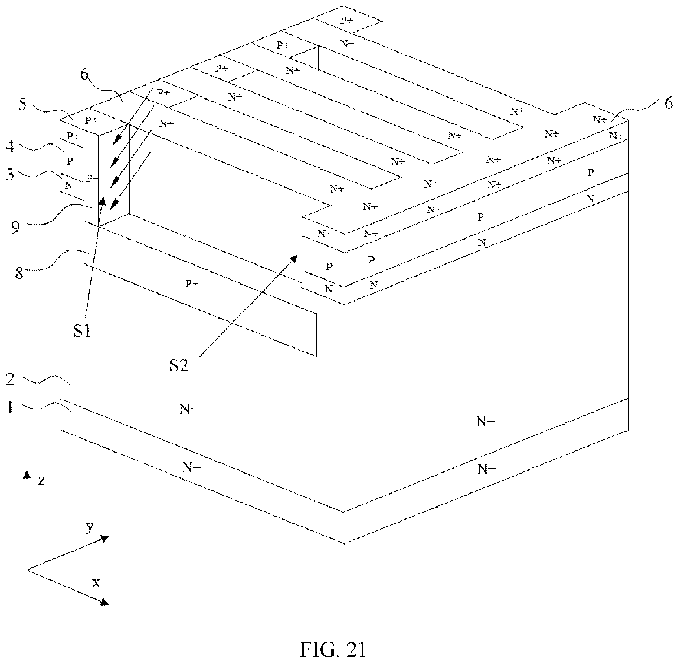

FIG. 19 shows a schematic diagram of a three-dimensional structure of a semiconductor device according to still another embodiment of this application. FIG. 20 shows a schematic diagram of a three-dimensional structure existing when the semiconductor device shown in FIG. 19 is not provided with an interlayer dielectric layer or a source. FIG. 21 shows a schematic diagram of a three-dimensional structure of a gate trench in the semiconductor device shown in FIG. 19

Refer to FIG. 19 to FIG. 21. In still some other embodiments provided in this application, the semiconductor device includes an N-type semiconductor substrate 1, a first epitaxial layer, a plurality of gate trenches 01 disposed at intervals, a gate 11, an interlayer dielectric layer 12, a source 13, and a drain 14. In addition, the first epitaxial layer includes a first N-type semiconductor region 2, a second N-type semiconductor region 3, a first P-type semiconductor region 4, source regions 6, a second P-type semiconductor region 8, third P-type semiconductor regions 9, and fourth P-type semiconductor regions 5. This embodiment is a variant of the implementations in the foregoing embodiment. The following describes only differences between this embodiment and the foregoing embodiment, and the same parts are not described herein again.

Refer to FIG. 19 to FIG. 21. In this embodiment, a plurality of third P-type semiconductor regions 9 are disposed. A first side wall S1 of each gate trench 01 is disposed with one of the plurality of third P-type semiconductor regions 9, and a second side wall S2 of each gate trench is not disposed with a third P-type semiconductor region 9. In other words, only the first side wall S1 of each gate trench 01 is disposed with the third P-type semiconductor region 9. In addition, each of the third P-type semiconductor regions 9 is in contact with the second P-type semiconductor region 8, so that each of the third P-type semiconductor regions 9 is connected to the second P-type semiconductor region 8 to perform signal transmission, and a voltage of each of the third P-type semiconductor regions 9 is the same as a voltage of the second P-type semiconductor region 8.

For example, refer to FIG. 19 to FIG. 21. A plurality of fourth P-type semiconductor regions 5 are also disposed, and the plurality of fourth P-type semiconductor regions 5 are disposed in a one-to-one correspondence and in contact with the plurality of third P-type semiconductor regions 9. One of the plurality of fourth P-type semiconductor regions 5 is disposed in correspondence with the third P-type semiconductor region 9 disposed on the first side wall S1, and the fourth P-type semiconductor region 5 is disposed on a side that is of the third P-type semiconductor region 9 and that is away from the first side wall S1 of the gate trench 01. The source 13 is connected to the second P-type semiconductor region 8 sequentially through the fourth P-type semiconductor region 5 and the third P-type semiconductor region 9 that are disposed in correspondence with each other, so that a voltage loaded on the source 13 is input to the second P-type semiconductor region 8 sequentially through the fourth P-type semiconductor region 5 and the third P-type semiconductor region 9, the second P-type semiconductor region 8 has a voltage, an electric field of a gate dielectric layer at a bottom of the gate trench 01 can be effectively shielded, and working robustness of the device is improved.

For example, refer to FIG. 19 to FIG. 21. Only the first side wall S1 of the gate trench 01 is disposed with the fourth P-type semiconductor region 5, and the second side wall S2 of the gate trench 01 is disposed with only the source region 6. The first P-type semiconductor region 4 on the second side wall S2 of the gate trench 01 may be controlled by a first gate 111 to form a channel, and the source region 6 is disposed on the second side wall S2 of the gate trench 01. In this way, a conduction current can be transmitted from the first P-type semiconductor region 4 on the second side wall S2 of the gate trench 01 to the drain 14, and a flow path of the conduction current is further improved.

For example, the structure shown in FIG. 19 is manufactured. For a flowchart of a corresponding manufacturing method, refer to FIG. 12. For steps S10, S30, and S50 to S90, refer to the description of the foregoing manufacturing method.

In this embodiment, step S20 is as follows: Perform ion implantation in a partial region of the first epitaxial layer by using an ion implantation process, to form the second N-type semiconductor region, the first P-type semiconductor region, and the source regions, where a region that is of the first epitaxial layer and in which ion implantation is not performed forms the first N-type semiconductor region.

For example, refer to FIG. 21. An N-type impurity is doped on a surface of the first epitaxial layer by using the ion implantation process, to form the second N-type semiconductor region 3. Then, a P-type impurity is doped on the surface of the first epitaxial layer by using the ion implantation process, to form the first P-type semiconductor region 4. Then, the N-type impurity is doped on the surface of the first epitaxial layer by using the ion implantation process, to form the source regions 6, and the P-type impurity is doped on a surface of the first epitaxial layer that is on the first side wall S1 of the gate trench 01, to form the fourth P-type semiconductor region 5 disposed at a same layer as the source region 6. Therefore, in this embodiment of this application, after the ion implantation process is performed, the partial region of the first epitaxial layer forms the second N-type semiconductor region 3, the first P-type semiconductor region 4, the source regions 6, and the fourth P-type semiconductor region 5, and the region that is of the first epitaxial layer and in which ion implantation is not performed by using the ion implantation process forms the first N-type semiconductor region 2.

In this embodiment, step S40 is as follows: Separately form, on the first side wall S1 of each gate trench 01 in a first direction by using a tilted ion implantation process, the third P-type semiconductor region 9 in contact with the second P-type semiconductor region 8.

For example, refer to FIG. 21. The P-type impurity is doped on a surface of the first side wall S1 of each gate trench 01 by using the tilted ion implantation process, to separately form the third P-type semiconductor region 9 in contact with the second P-type semiconductor region 8.

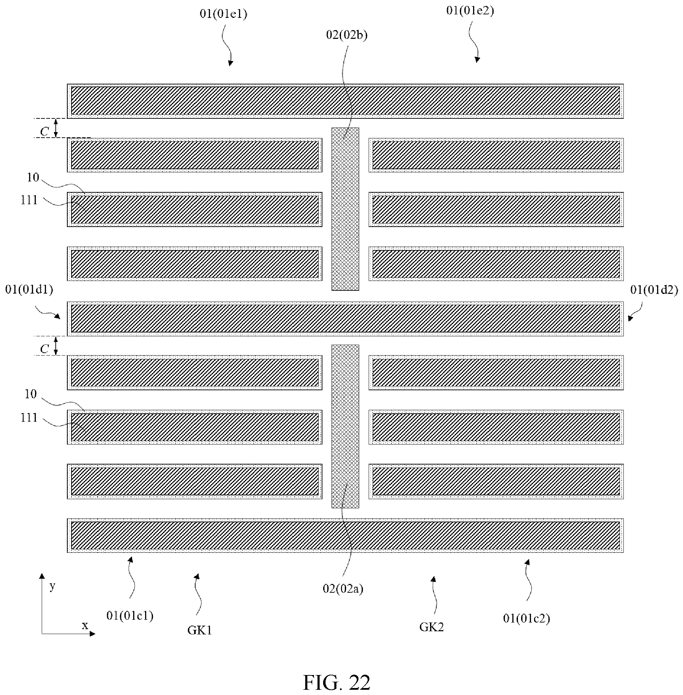

FIG. 22 shows a schematic diagram of a top-view structure of a semiconductor device according to another embodiment of this application.

Refer to FIG. 22. In still some other embodiments provided in this application, the semiconductor device includes an N-type semiconductor substrate 1, a first epitaxial layer, a plurality of gate trenches 01 disposed at intervals, a gate 11, an interlayer dielectric layer 12, a source 13, and a drain 14. In addition, the first epitaxial layer includes a first N-type semiconductor region 2, a second N-type semiconductor region 3, a first P-type semiconductor region 4, source regions 6, a second P-type semiconductor region 8, third P-type semiconductor regions 9, and fourth P-type semiconductor regions 5. This embodiment is a variant of the implementations in the foregoing embodiment. The following describes only differences between this embodiment and the foregoing embodiment, and the same parts are not described herein again.

Refer to FIG. 22. In at least some gate trenches 01 in two adjacent trench groups, gate trenches 01 arranged in a first direction x communicate with each other. For example, a gate trench 01c1 in a trench group GK1 and a gate trench 01 c2 in a trench group GK2 are arranged in the first direction x, and the gate trench 01c1 and the gate trench 01c2 communicate with each other. A gate trench 01d1 in the trench group GK1 and a gate trench 01d2 in the trench group GK2 are arranged in the first direction x, and the gate trench 01d1 and the gate trench 01d2 communicate with each other. A gate trench 01e 1 in the trench group GK1 and a gate trench 01e2 in the trench group GK2 are arranged in the first direction, and the gate trench 01e1 and the gate trench 01e2 communicate with each other.

For example, in this application, the plurality of gate trenches include a first gate trench and a second gate trench that communicate with each other in the first direction x. The first gate trench and the second gate trench are respectively located in two adjacent trench groups. To be specific, the first gate trench is located in one of the two adjacent trench groups, the second gate trench is located in the other of the two adjacent trench groups, and the first gate trench and the second gate trench communicate with each other. For example, refer to FIG. 22. The gate trench 01c1 in the trench group GK1 may be a first gate trench, the gate trench 01 c2 in the trench group GK2 may be a second gate trench, and the gate trench 01c1 in the trench group GK1 and the gate trench 01c2 in the trench group GK2 communicate with each other. The gate trench 01d1 in the trench group GK1 may be a first gate trench, the gate trench 01d2 in the trench group GK2 may be a second gate trench, and the gate trench 01d1 in the trench group GK1 and the gate trench 01d2 in the trench group GK2 communicate with each other. The gate trench 01e1 in the trench group GK1 may be a first gate trench, the gate trench 01e2 in the trench group GK2 may be a second gate trench, and the gate trench 01e1 in the trench group GK1 and the gate trench 01e2 in the trench group GK2 communicate with each other.

Refer to FIG. 22. A contact hole 02 includes a plurality of contact sub-holes that are disposed at intervals, and at least one gate trench 01 that is through is disposed between two adjacent contact sub-holes in a same contact hole 02. A quantity of the contact sub-holes that the contact hole 02 is divided into is not limited in this application. For example, there may be two, three, four, or more contact sub-holes. In addition, a quantity of gate trenches 01 that are through and that are disposed between two adjacent contact sub-holes in a same contact hole 02 is not limited in this application. For example, there may be one, two, three, four, or more gate trenches. In this way, design freedom of the contact hole 02 can be improved, and through-current uniformity of a SiC MOSFET device can be improved.

For example, refer to FIG. 22. The contact hole includes a contact sub-hole 02a and a contact sub-hole 02b that are disposed at an interval. A gate trench that is formed by a gate trench 01d1 and a gate trench 01d2 that communicate with each other is disposed between the contact sub-hole 02a and the contact sub-hole 02b.

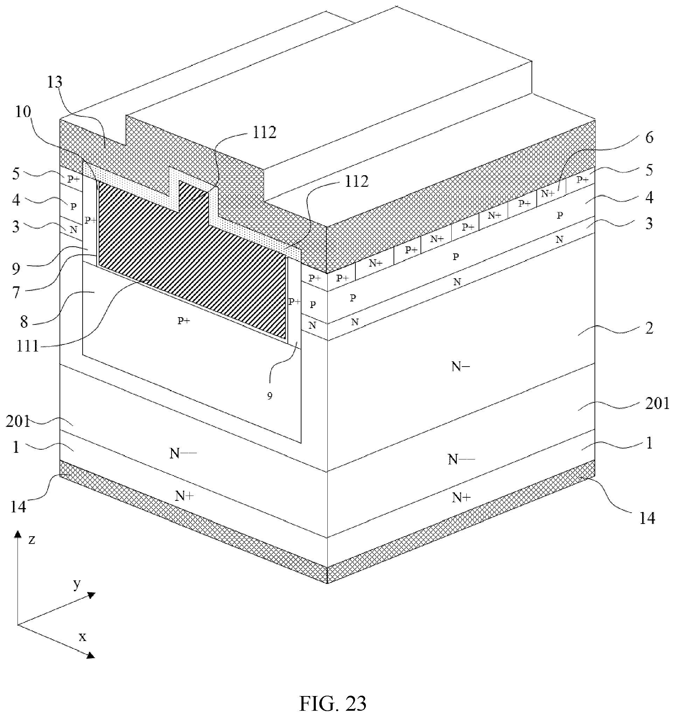

FIG. 23 shows a schematic diagram of a three-dimensional structure of a semiconductor device according to still another embodiment of this application.

Refer to FIG. 23. In still some other embodiments provided in this application, the semiconductor device includes an N-type semiconductor substrate 1, a first epitaxial layer, a second epitaxial layer 201, a plurality of gate trenches 01 disposed at intervals, a gate 11, an interlayer dielectric layer 12, a source 13, and a drain 14. In addition, the first epitaxial layer includes a first N-type semiconductor region 2, a second N-type semiconductor region 3, a first P-type semiconductor region 4, source regions 6, a second P-type semiconductor region 8, third P-type semiconductor regions 9, and fourth P-type semiconductor regions 5. This embodiment is a variant of the implementations in the foregoing embodiment. The following describes only differences between this embodiment and the foregoing embodiment, and the same parts are not described herein again.

Refer to FIG. 23. The second epitaxial layer 201 is disposed between the first epitaxial layer (for example, the first N-type semiconductor region 2) and the semiconductor substrate 1. Because the second epitaxial layer 201 is disposed, a thickness of the second P-type semiconductor region 8 at the first epitaxial layer 100 in a third direction z may be set to be thicker. For example, the thickness of the second P-type semiconductor region 8 in the third direction z may be set to be greater than 1 µm.

Refer to FIG. 23. In this embodiment, the second epitaxial layer 201 is an N-type semiconductor region. For example, the second epitaxial layer 201 is SiC doped with an N-type impurity. The N-type impurity is, for example, nitrogen (N), phosphorus (P), or arsenic (As). For example, a doping concentration of the second epitaxial layer 201 is less than a doping concentration of the first N-type semiconductor region 2.

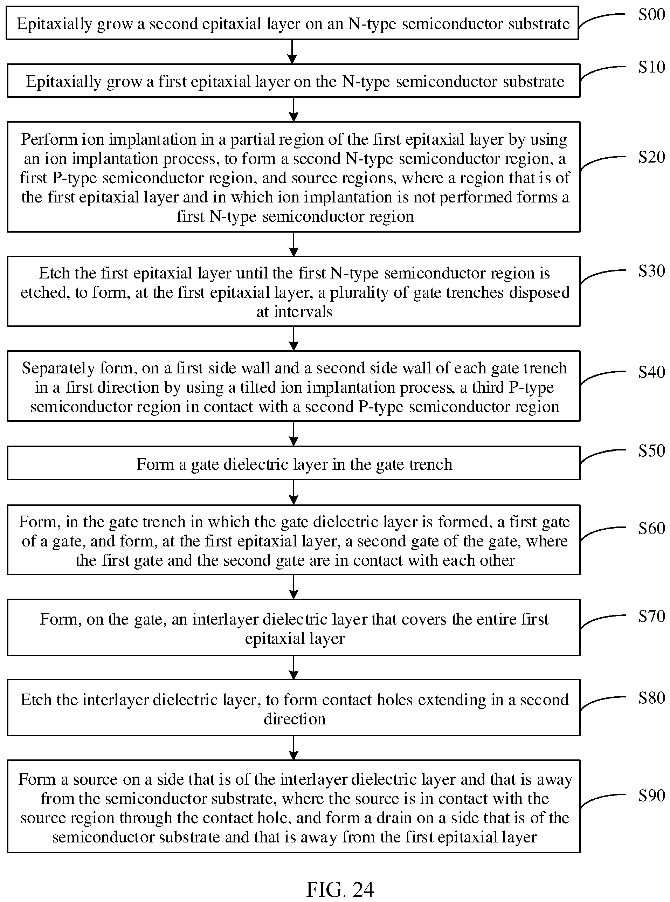

For example, the structure shown in FIG. 23 is manufactured. For a flowchart of a corresponding manufacturing method, refer to FIG. 24. For steps S10 to S90, refer to the description of the foregoing manufacturing method.

Before step S10, the manufacturing method further includes step 500: Epitaxially grow the second epitaxial layer on the N-type semiconductor substrate 1.

For example, refer to FIG. 23. On the N-type SiC semiconductor substrate 1, a SiC material doped with the N-type impurity is epitaxially grown on the N-type SiC semiconductor substrate 1 by using an epitaxial growth process, to form the second epitaxial layer 201.

An embodiment of this application further provides a power conversion circuit. The power conversion circuit may be an alternating current-direct current conversion circuit and/or a direct current-direct current conversion circuit. The power conversion circuit may include a circuit board and one or more semiconductor devices, and the semiconductor device is connected to the circuit board. Because performance of the foregoing semiconductor device is good, performance of a power conversion circuit including the foregoing semiconductor device is also good. In addition, a problem-resolving principle of the power conversion circuit is similar to a problem-resolving principle of the foregoing semiconductor device. Therefore, for technical effects of the power conversion circuit, refer to technical effects of the foregoing semiconductor device. Repeated content is not described again.

An embodiment of this application further provides a vehicle, and the vehicle includes a power conversion circuit provided in an embodiment of this application. Because performance of the foregoing power conversion circuit is good, circuit performance of a vehicle including the foregoing power conversion circuit is also good. In addition, a problem-resolving principle of the vehicle is similar to a problem-resolving principle of the foregoing power conversion circuit. Therefore, for technical effects of the vehicle, refer to technical effects of the foregoing power conversion circuit. Repeated content is not described again.

Apparently, a person skilled in the art can make various modifications and variations to this application without departing from the scope of this application. This application is intended to cover these modifications and variations of this application provided that they fall within the scope of the claims of this application and an equivalent technology thereof.

## Claims

1. A semiconductor device, comprising:
an N-type semiconductor substrate;
a first epitaxial layer, wherein the first epitaxial layer is disposed on the semiconductor substrate;
a plurality of gate trenches disposed at intervals, wherein the plurality of gate trenches extend to the first epitaxial layer in a third direction perpendicular to a plane on which the semiconductor substrate is located, the plurality of gate trenches extend in a first direction parallel to the plane on which the semiconductor substrate is located, and the plurality of gate trenches are arranged in a second direction parallel to the plane on which the semiconductor substrate is located, wherein the first direction, the second direction, and the third direction are set in a cross manner;
a gate, wherein the gate comprises a first gate and a second gate that are in contact with each other, the first gate is filled and disposed in the gate trench, and is spaced apart by a gate dielectric layer, and the second gate is disposed on top of the first epitaxial layer and is spaced apart by the gate dielectric layer;
an interlayer dielectric layer, wherein the interlayer dielectric layer covers a side that is of the gate and that is away from the semiconductor substrate, the interlayer dielectric layer has contact holes, the contact hole extends in the second direction, an orthographic projection of the contact hole on the semiconductor substrate does not overlap an orthographic projection of the gate on the semiconductor substrate, and the contact hole exposes a partial region of the first epitaxial layer;
a source, wherein the source is disposed on a side that is of the interlayer dielectric layer and that is away from the semiconductor substrate, and the source is in contact, through the contact hole, with the first epitaxial layer exposed by the contact hole; and
a drain, wherein the drain is disposed on a side that is of the semiconductor substrate and that is away from the first epitaxial layer.

2. The semiconductor device according to claim 1, wherein the plurality of gate trenches are divided into at least one trench group, and there are at least two contact holes; and
one trench group is disposed between two adjacent contact holes, and the contact hole spans across the trench group in the second direction.

3. The semiconductor device according to claim 2, wherein quantities of gate trenches in different trench groups are the same.

4. The semiconductor device according to claim 2 or 3, wherein the plurality of gate trenches comprise a first gate trench and a second gate trench that communicate with each other in the first direction, and the first gate trench and the second gate trench are respectively located in two adjacent trench groups; and
the contact hole comprises a plurality of contact sub-holes that are disposed at intervals, and at least one gate trench that is through is disposed between two adjacent contact sub-holes in a same contact hole.

5. The semiconductor device according to any one of claims 1 to 4, wherein the first epitaxial layer comprises: a first N-type semiconductor region, a second N-type semiconductor region, a first P-type semiconductor region, and source regions, wherein the first N-type semiconductor region is disposed between the second N-type semiconductor region and the semiconductor substrate, the first P-type semiconductor region is disposed on a side that is of the second N-type semiconductor region and that is away from the semiconductor substrate, and the source region is disposed on a side that is of the first P-type semiconductor region and that is away from the semiconductor substrate;
in the third direction perpendicular to the plane on which the semiconductor substrate is located, the gate trench extends to the first N-type semiconductor region; and
the contact hole exposes a partial region of the source region.

6. The semiconductor device according to any one of claims 1 to 5, wherein the first epitaxial layer further comprises:
a second P-type semiconductor region, wherein the second P-type semiconductor region is disposed below the gate trench, and the second P-type semiconductor region is connected to the source.

7. The semiconductor device according to claim 6, wherein in the first direction, the gate trench has a first side wall and a second side wall that are disposed opposite to each other; and
the first epitaxial layer further comprises:
a third P-type semiconductor region, wherein the third P-type semiconductor region is disposed on a first side wall and/or a second side wall of at least one gate trench, and the third P-type semiconductor region is in contact with the second P-type semiconductor region; and
a fourth P-type semiconductor region, wherein the fourth P-type semiconductor region and the source region are disposed at a same layer, the fourth P-type semiconductor region is disposed on a side that is of the third P-type semiconductor region and that is away from the gate trench, the fourth P-type semiconductor region is in contact with the third P-type semiconductor region, and the fourth P-type semiconductor region is in contact with the source through the contact hole.

8. The semiconductor device according to claim 7, wherein the first epitaxial layer further comprises:
fifth P-type semiconductor regions, wherein the fifth P-type semiconductor region and the source region are disposed at a same layer, the fifth P-type semiconductor region is disposed on a side that is of a side wall of the gate trench and that is not disposed with a third P-type semiconductor region, and the fifth P-type semiconductor region is in contact with the corresponding source through the contact hole.

9. The semiconductor device according to claim 8, wherein there are a plurality of fifth P-type semiconductor regions, and the plurality of fifth P-type semiconductor regions are disposed in a one-to-one correspondence with second side walls of the plurality of gate trenches; and
there are a plurality of source regions, and the gate trenches and the plurality of source regions are alternately disposed.

10. The semiconductor device according to any one of claims 6 to 9, wherein an orthographic projection of the second P-type semiconductor region on the semiconductor substrate covers an orthographic projection of the gate trench on the semiconductor substrate and an orthographic projection of the third P-type semiconductor region on the semiconductor substrate.

11. The semiconductor device according to claim 10, wherein the second P-type semiconductor region is a planar region extending in the second direction; and
the orthographic projection of the second P-type semiconductor region on the semiconductor substrate further covers a gap between orthographic projections of two adjacent gate trenches on the semiconductor substrate.

12. The semiconductor device according to any one of claims 5 to 11, wherein the semiconductor device further comprises:
an N-type second epitaxial layer, wherein the second epitaxial layer is disposed between the first epitaxial layer and the semiconductor substrate, and a doping concentration of the second epitaxial layer is less than a doping concentration of the first N-type semiconductor region; and
a thickness of the second epitaxial layer in the third direction is greater than 1 µm.

13. The semiconductor device according to any one of claims 1 to 12, wherein materials of the semiconductor substrate, the first epitaxial layer, and the second epitaxial layer are SiC.

14. A manufacturing method for a semiconductor device, comprising:
epitaxially growing a first epitaxial layer on an N-type semiconductor substrate;
etching the first epitaxial layer to form a plurality of gate trenches that are disposed at intervals and that extend to the first epitaxial layer in a third direction perpendicular to a plane on which the semiconductor substrate is located, wherein the plurality of gate trenches extend in a first direction parallel to the plane on which the semiconductor substrate is located, the plurality of gate trenches are arranged in a second direction parallel to the plane on which the semiconductor substrate is located, and the first direction, the second direction, and the third direction are set in a cross manner;
forming a gate dielectric layer in the gate trench;
forming, in the gate trench in which the gate dielectric layer is formed, a first gate of a gate, and forming, on top of the first epitaxial layer, a second gate of the gate, wherein the first gate and the second gate are in contact with each other;
forming, on the gate, an interlayer dielectric layer that covers the entire first epitaxial layer;
etching the interlayer dielectric layer to form contact holes extending in the second direction, wherein the contact hole exposes a partial region of the first epitaxial layer, and an orthographic projection of the contact hole on the semiconductor substrate does not overlap an orthographic projection of the gate on the semiconductor substrate; and
forming a source on a side that is of the interlayer dielectric layer and that is away from the semiconductor substrate, wherein the source is in contact, through the contact hole, with the first epitaxial layer exposed by the contact hole, and forming a drain on a side that is of the semiconductor substrate and that is away from the first epitaxial layer.

15. The manufacturing method according to claim 14, wherein after the epitaxially growing a first epitaxial layer on an N-type semiconductor substrate, the manufacturing method further comprises:
performing, by using an ion implantation process, ion implantation in a partial region of the first epitaxial layer, to form a second N-type semiconductor region, a first P-type semiconductor region, and source regions, wherein a region that is of the first epitaxial layer and in which ion implantation is not performed forms a first N-type semiconductor region, the first N-type semiconductor region is disposed between the second N-type semiconductor region and the semiconductor substrate, the first P-type semiconductor region is disposed on a side that is of the first N-type semiconductor region and that is away from the semiconductor substrate, and the source region is disposed on the side that is of the first P-type semiconductor region and that is away from the semiconductor substrate, wherein
the contact hole exposes a partial region of the source region.

16. The manufacturing method according to claim 15, wherein the epitaxially growing a first epitaxial layer on an N-type semiconductor substrate comprises:
epitaxially growing, on the N-type semiconductor substrate, a first epitaxial layer that reaches a first specified thickness;
performing ion implantation at the first epitaxial layer by using the ion implantation process, to form a second P-type semiconductor region; and
continuing epitaxial growth at the first epitaxial layer at which the second P-type semiconductor region is formed, until a first epitaxial layer that reaches a second specified thickness is formed.

17. The manufacturing method according to claim 16, wherein the manufacturing method further comprises:
when the source region is formed, forming, by using the ion implantation process and at the first epitaxial layer, a fourth P-type semiconductor region disposed at a same layer as the source region; and
the manufacturing method further comprises:
before the forming a gate dielectric layer in the gate trench, forming, on at least one side wall of the gate trench in the first direction by using a tilted ion implantation process, a third P-type semiconductor region in contact with the second P-type semiconductor region.

18. A power conversion circuit, comprising a circuit board and one or more semiconductor devices according to any one of claims 1 to 13, wherein the semiconductor device is connected to the circuit board.

19. A vehicle, comprising the power conversion circuit according to claim 18, wherein the power conversion circuit is configured to convert an alternating current and/or a direct current and output a direct current.
